# EUROPEAN PATENT SPECIFICATION

(11) **EP 2 056 164 B1**
(45) Date of publication and mention of the grant of the patent: **27.03.2013**
(21) Application number: 08253577.4
(22) Date of filing: 31.10.2008
(51) Int. Cl.: G03F 7/20

(54) **Cleaning apparatus and immersion lithographic apparatus**
Reinigungsvorrichtung und Immersionslithographievorrichtung
Appareil de nettoyage et appareil lithographique de type à immersion

(30) Priority: 31.10.2007 US 1050 P; 07.02.2008 US 6951 P
(43) Date of publication of application: 06.05.2009
(73) Proprietor: ASML Netherlands B.V., 5504 DR Veldhoven (NL)
(72) Inventor: De Jong, Anthonius M.C.P., 2642 CV Pijnacker (NL); Jansen, Hans, 5653 PP Eindhoven (NL); Leenders, Martinus H.A., 3161 JG Rhoon (NL); Blom, Paul, 5506 BK Veldhoven (NL); Kramer, Ronald H.G., 5095 AZ Hooge Mierde (NL); Van Putten, Michel, 2624 CP Delft (NL); De Graaf, Ariël, 511 BV Utrecht (NL)
(74) Representative: Corcoran, Gregory Martin Mason

(56) References cited:
- EP-A- 1 391 786
- EP-A- 1 429 189
- EP-A- 1 821 337
- EP-A- 2 019 335
- WO-A-2006/027900
- WO-A-2006/137410

## Description

### Field

The present invention relates to a cleaning apparatus and an immersion lithographic apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. The liquid may be distilled water, although another liquid could be used. The description herein references a liquid. However, another fluid may be suitable, particularly a wetting fluid, incompressible fluid and/or a fluid with a higher refractive index than air, desirably a higher refractive index than water, such as a hydrocarbon, such as a hydrofluorocarbon. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein and particles having the same refractive index as the liquid within which they are suspended. The particles may be of the size of nanoparticles. They may be provided in a concentration that increases the refractive index of the liquid in which they are suspended.

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

In an immersion apparatus, immersion liquid is handled by a fluid handling system, structure or apparatus. In an embodiment the fluid handling system may supply immersion fluid or liquid and therefore be a fluid supply system. In an embodiment the fluid handling system may at least partly confine fluid and thereby be a fluid confinement system. In an embodiment the fluid handling system may provide a barrier to fluid and thereby be a barrier member, such as a fluid confinement structure. In an embodiment the fluid handling system may create or use a flow of gas, for example to help in controlling the flow and/or the position of liquid. The flow of gas may form a seal to confine the fluid so the fluid handling structure may be referred to a seal member; such a seal member may be a fluid confinement structure. In an embodiment immersion liquid rather than immersion fluid is used. In that case the fluid handling system may be a liquid handling system. In reference to the aforementioned description, reference in this paragraph to a feature defined with respect to fluid may be understood to include a feature defined with respect to liquid.

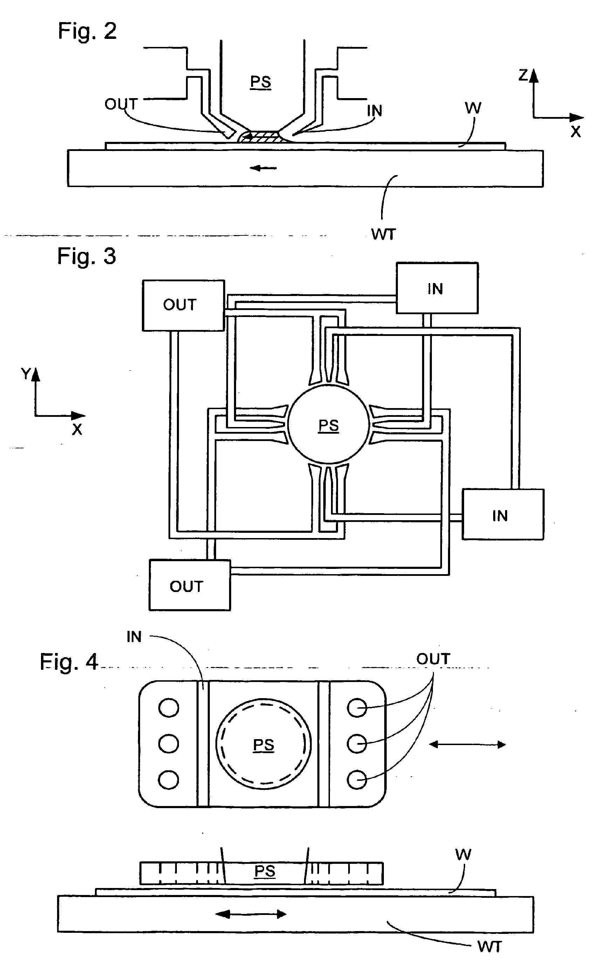

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible; one example is illustrated in Figure 3 in which four sets of an inlet IN with an outlet OUT on either side are provided in a regular pattern around the final element.

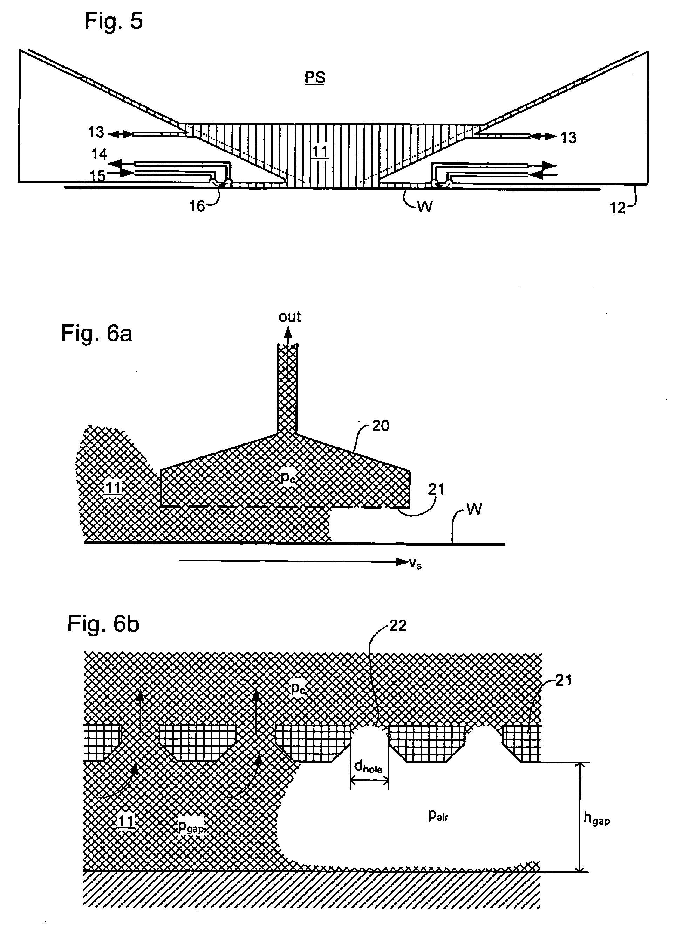

Another solution which has been proposed is to provide the liquid supply system with a seal member which extends along at least a part of a boundary of the space between the final element of the projection system and the substrate table. Such a solution is illustrated in Figure 4. The seal member is substantially stationary relative to the projection system PS in the XY plane though there may be some relative movement in the Z direction (in the direction of the optical axis). A seal is formed between the seal member and the surface of the substrate W. Preferably the seal is a contactless seal such as a gas seal. Such a system with a gas seal is illustrated in Figure 5 and is disclosed in EP-A-1,420,298.

In EP-A-1,420,300 the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage.

One problem encountered with immersion lithographic machines is the occurrence of contaminating particles within the immersion system and on the surface of the wafer. The presence of a particle in the immersion system may cause defects to occur during the exposure process if the particle is present between the projection system and the substrate being exposed. It is therefore desirable to reduce optimally the presence of particles in the immersion system.

EP-A-1,429,189 discloses a device for cleaning contaminants from the surface of optical elements in exposure apparatus employing EUV radiation. The device comprises a downstream radical source for providing a beam of radicals and means for directing the beam of radicals onto a surface to be cleaned.

EP-A-1,821,337 discloses a method of cleaning a nozzle member of an immersion lithographic apparatus by immersing the nozzle member in a liquid stored in a container.

WO 2006/027900 A, which relates to immersion lithography, discloses an apparatus for cleaning the surface of a substrate.

### SUMMARY

It is desirable to provide an immersion lithographic apparatus which is capable of cleaning the surface of the immersion system and/or the wafer.

According to an aspect of the invention, there is provided a cleaning apparatus for cleaning a substrate or component of an immersion lithographic apparatus and an immersion lithographic apparatus as specified in the claims.

According to an aspect of the invention, there is provided a method for cleaning a substrate or component of an immersion lithographic apparatus as specified in the claims.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus according the invention;
- Figures 2 and 3 depict an embodiment of a liquid supply system used in lithographic projection apparatus;
- Figure 4 depicts an embodiment of a liquid supply system used in a lithographic projection apparatus;
- Figure 5 depicts an embodiment of a liquid supply system;
- Figure 6 depicts features of an embodiment of a liquid supply system;
- Figure 7 depicts an embodiment of a part of an immersion lithographic apparatus and a cleaning apparatus according to the invention;
- Figure 8 depicts an embodiment of a part of an immersion lithographic apparatus and a cleaning apparatus according to the invention;
- Figure 9 depicts an embodiment of part of an immersion lithographic apparatus and a cleaning apparatus according to the invention;
- Figure 10 depicts an embodiment of part of an immersion lithographic apparatus and a cleaning apparatus according to the invention;
- Figure 11 depicts an embodiment of part of a substrate and a cleaning apparatus according to the invention;
- Figure 12 depicts an embodiment of part of a substrate and a cleaning apparatus according to the invention;
- Figure 13 depicts an embodiment of part of a substrate and a cleaning apparatus according to the invention;
- Figure 14 depicts an embodiment of part of an immersion lithographic apparatus and a cleaning apparatus according to the invention;
- Figure 15 depicts an embodiment of a source of radicals according to the invention;
- Figure 16 depicts an embodiment of a cleaning apparatus according to the invention; and
- Figure 17 depicts an embodiment of a cleaning apparatus according to the invention.

### DETAILED DESCRIPTION

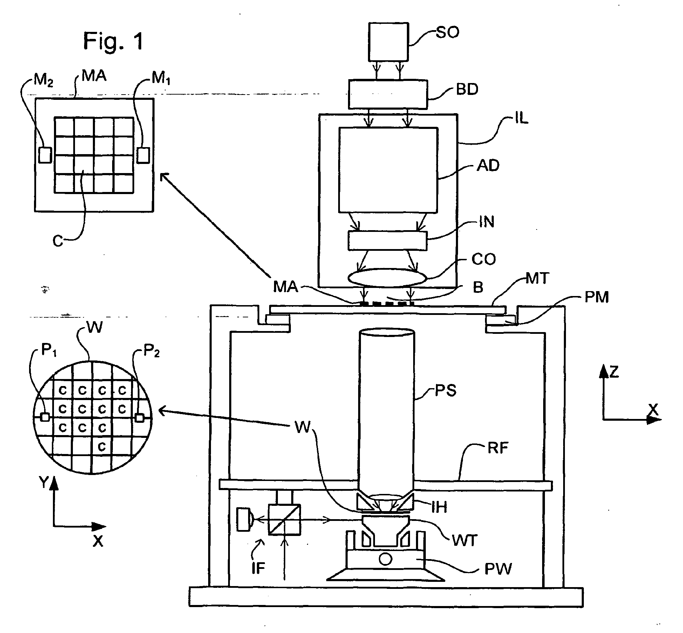

Figure 1 schematically depicts an embodiment of lithographic apparatus suitable for use with the invention. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device MA in accordance with certain parameters;
- a substrate table (e.g. a wafer table) WT constructed to hold a substrate (e.g. a resist-coated wafer) W and connected to a second positioner PW configured to accurately - position the substrate W in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT supports, i.e. bears the weight of, the patterning device MA. It holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source SO and the lithographic apparatus may be separate entities, for example when the source SO is an excimer laser. In such cases, the source SO is not considered to form part of the lithographic apparatus and the radiation beam is passed from the source SO to the illuminator IL with the aid of a beam delivery system BD comprising, for example, suitable directing mirrors and/or a beam expander. In other cases the source SO may be an integral part of the lithographic apparatus, for example when the source SO is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and α-inner, respectively) of the intensity distribution in a pupil plane of the illuminator IL can be adjusted. In addition, the illuminator IL may comprise various other components, such as an integrator IN and a condenser CO. The illuminator IL may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam B is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion C in a single dynamic exposure, whereas the length of the scanning motion determines the height (in the scanning direction) of the target portion C.
3. In another mode, the mask table MT is kept essentially stationary holding a programmable patterning device, and the substrate table WT is moved or scanned while a pattern imparted to the radiation beam B is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

An immersion lithography solution with a localized liquid supply system is shown in Figure 4. Liquid is supplied by two groove inlets IN on either side of the projection system PS and is removed by a plurality of discrete outlets OUT arranged radially outwardly of the inlets IN. The inlets IN and OUT can be arranged in a plate with a hole in its centre and through which the projection is project. Liquid is supplied by one groove inlet IN on one side of the projection system PS and removed by a plurality of discrete outlets OUT on the other side of the projection system PS, causing a flow of a thin film of liquid between the projection system PS and the projection system PS and removed by a plurality of discrete outlets OUT on the other side of the projection system PS, causing a flow of a thin film of liquid between the projection system PS and the substrate W. The choice of which combination of inlet IN and outlets OUT to use can depend on the direction of movement of the substrate W (the other combination of inlet IN and outlets OUT being inactive).

Another immersion lithography solution with a localized liquid supply system solution which has been proposed is to provide the liquid supply system with a seal member (or so-called immersion hood) which extends along at least a part of a boundary of the space between the final element of the projection system and the substrate table. Such a solution is illustrated in Figure 5. The seal member is substantially stationary relative to the projection system PS in the XY plane though there may be some relative movement in the Z direction (in the direction of the optical axis). A seal is formed between the seal member and the surface of the substrate W.

Referring to Figure 5, a seal member 12 forms a contactless seal to the substrate W around the image field of the projection system PS so that liquid is confined to fill a reservoir or an immersion space 11 between the substrate surface and the final element of the projection system PS. The reservoir 11 is formed by a seal member 12 positioned below and surrounding the final element of the projection system PS. Liquid is brought into the space 11 below the projection system PS and within the seal member 12. The seal member 12 extends a little above the final element of the projection system PS and the liquid rises above the final element so that a buffer of liquid is provided. The seal member 12 has an inner periphery that at the upper end, in an embodiment, closely conforms to the shape of the projection system PS or the final element thereof and may, e.g., be round. At the bottom, the inner periphery closely conforms to the shape of the image field, e.g., rectangular though this need not be the case.

The liquid is confined in the reservoir 11 by a gas seal 16 between the bottom of the seal member 12 and the surface of the substrate W. The gas seal 16 is formed by gas, e.g. air or synthetic air but, in an embodiment, N₂ or another inert gas, provided under pressure via inlet 15 to the gap between seal member 12 and substrate W and extracted via first outlet 14. The overpressure on the gas inlet 15, vacuum level on the first outlet 14 and geometry of the gap are arranged so that there is a high-velocity gas flow inwards that confines the liquid. Such a system is disclosed in United States patent application publication no. US 2004-0207824.

Other solutions are possible and one or more embodiments of the present invention are equally applicable to those. For example, in place of the gas seal 16 it is possible to have a single phase extractor which only extracts liquid. Radially outwardly of such a single phase extractor could be one or more features to produce a gas flow to help contain the liquid in the space 11. One such type of feature might be a so-called gas knife in which a thin jet of gas is directed downwards onto the substrate W. During scanning motion of the substrate W under the projection system PS and the liquid supply system, hydrostatic and hydrodynamic forces may be generated which result in pressures on the liquid downwards towards the substrate W.

With a localized area liquid supply system, the substrate W is moved under the projection system PS and the liquid supply system. The relative movement of the table may be to enable an edge of the substrate W is to be imaged or a sensor on the substrate table WT to be imaged for sensing purposes or for substrate swap. Substrate swap is removal and replacement of the substrate W from the substrate table WT between exposures of different substrates. During substrate swap it may be desirable for liquid to be kept within the fluid confinement structure 12. This is achieved by moving the fluid- confinement structure 12 relative to the substrate table WT, or vice versa, so that the fluid confinement structure 12 is placed over a surface of the substrate table WT away from the substrate W. Such a surface is a shutter member. Immersion liquid may be retained in the fluid confinement structure 12 by operating the gas seal 16 or by clamping the surface of the shutter member to the undersurface of the fluid confinement structure 12. The clamping may be achieved by controlling the flow and/or pressure of fluid provided to the undersurface of the fluid confinement structure 12. For example, the pressure of gas supplied from the inlet 15 and/or the under pressure exerted from the first outlet 14 may be controlled.

The surface of substrate table WT over which the fluid confinement structure 12 is placed may be an integral part of the substrate table WT or it may be a detachable and or replaceable component of the substrate table WT. Such a detachable component may be referred to as closing disc or a dummy substrate. The detachable or separable component may be a separate stage. In a dual or multi stage arrangement the entire substrate table WT is replaced during substrate exchange. In such an arrangement the detachable component may be transferred between substrate tables. The shutter member may be an intermediate table that may be-moved adjacent to the substrate table WT prior to substrate exchange. The fluid confinement structure 12 may then be moved onto the intermediate table, or vice versa during substrate exchange. The shutter member may be a moveable component of the substrate table WT, such as a retractable bridge, which may be positioned between the stages during substrate exchange. The surface of the shutter member may be moved under the fluid confinement structure 12, or vice versa, during substrate exchange.

During substrate swap, an edge of the substrate W will pass under the space 11 and liquid may leak into the gap between the substrate W and substrate table WT. This liquid may be forced in-under hydrostatic or hydrodynamic pressure or the force of a gas knife or other gas flow creating device. A drain may be provided around the edge of a substrate W, such as in the gap. A drain may be located around another object on the substrate table WT. Such an object may include, but is not limited to, one or more sensors and/or a shutter member used to maintain liquid in the liquid supply system by being attached to the bottom of the liquid supply system during, for example, substrate swap. Thus, any reference to the substrate W should be considered to be synonymous with any such other object, including a sensor or shutter member, such as a closing plate.

Figures 6a and 6b, the latter of which is an enlarged view of part of the former, illustrate a liquid removal device 20 which may be used in immersion systems to remove liquid between the immersion hood IH and the substrate W. The liquid removal device 20 comprises a chamber which is maintained at a slight underpressure p_{c} and is filled with the immersion liquid. The lower surface of the chamber is formed of a porous member 21 having a plurality of small holes, e.g. of diameter dₕₒₗₑ in the range of 5 to 50µm, and is maintained at a height h_{gap} less than 1 mm, desirably in the range of 50 to 300µm above a surface from which liquid is to be removed, e.g. the surface of a substrate W. The porous member 21 may be a perforated plate or any other suitable structure that is configured to allow the liquid to pass there through. In an embodiment, porous member 21 is at least slightly hydrophilic, i.e. having a contact angle of less than 90° to the immersion liquid, e.g. water.

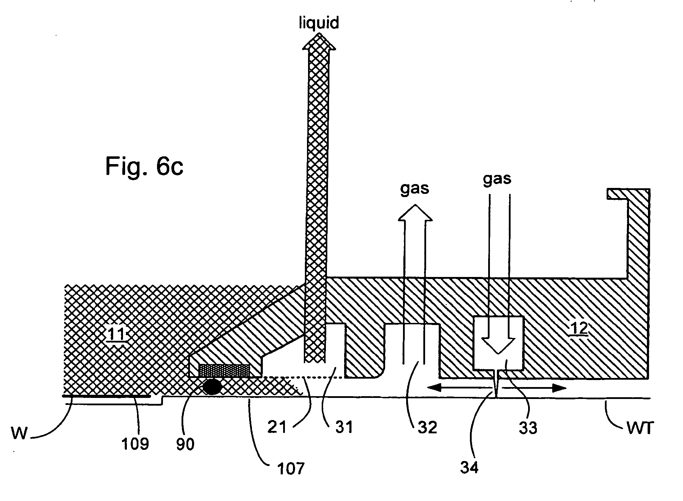

Such liquid removal devices can be incorporated into many types of seal member 12 of an immersion hood IH. One example is illustrated in Figure 6c as disclosed in USSN 10/921,348 filed 19 August 2004. Figure 6c is a cross-sectional view of one side of the seal member 12, which forms a ring (as used herein, a ring may be circular, rectangular or any other shape and it may be continuous or discontinuous) at least partially around the exposure field of the projection system PS (not shown in Figure 6c). In this embodiment, the liquid removal device is formed by a ring-shaped chamber 31 near the innermost edge of the underside of the seal member 12. The lower surface of the chamber 31 is formed by a porous member 21 such as the porous member described above. Ring-shaped chamber 31 is connected to a suitable pump or pumps to remove liquid from the chamber 31 and maintain the desired underpressure. In use, the chamber 31 is full of liquid but is shown empty here for clarity.

Outward of the ring-shaped chamber 31 may be a gas extraction ring 32 and a gas supply ring 33. The gas supply ring 33 may have a narrow slit in its lower part and is supplied with gas, e.g. air, artificial air or flushing gas, at a pressure such that the gas escaping out of the slit forms a gas knife 34. The gas forming the gas knife 34 is extracted by a suitable vacuum pumps connected to the gas extraction ring 32 so that the resulting gas flow drives any residual liquid inwardly where it can be removed by the liquid removal device and/or the vacuum pumps, which should be able to tolerate vapor of the immersion liquid and/or small liquid droplets. However, since the majority of the liquid is removed by the liquid removal device, the small amount of liquid removed via the vacuum system does not cause unstable flows which may lead to vibration.

While the chamber 31, gas extraction ring 32, gas supply ring 33 and other rings are described as rings herein, it is not necessary that they surround the exposure field or be complete. They may be continuous or discontinuous. In an embodiment, such inlet(s) and outlet(s) may simply be any annular shape such as circular, rectangular or other type of elements extending partially along one or more sides of the exposure field, such as for example, shown in Figures 2, 3 and 4.

In the apparatus shown in Figure 6c, most of the gas that forms the gas knife 34 is extracted via gas extraction ring 32, but some gas may flow into the environment around the immersion hood and potentially disturb the interferometric position measuring system IF. This can be prevented by the provision of an additional gas extraction ring outside the gas knife (not illustrated).

Further examples of how such single phase extractors can be used in an immersion hood or fluid confinement system or liquid supply system can be found, for example in EP 1,628,163 and USSN 60/643,626. In most applications the porous member will be on an underside of the liquid supply system and the maximum speed at which the substrate W can move under the projection system PS is at least in part determined by the efficiency of removal of liquid through the porous member 21.

Single phase extractors can also be used in two phase mode in which both liquid and gas are extracted (say 50% gas, 50% liquid). The term single phase extractor is not intended herein to be interpreted only as an extractor which extracts one phase, but more generally as an extractor which incorporates a porous member through which gas and/or liquid is/are extracted. In an embodiment of the gas knife (i.e. the gas supply ring 33) may be absent.

The above mentioned single phase extractor can be used in liquid supply systems which supply liquid to only a localized area of the top surface of the substrate. Furthermore, such extractors can also be used in other types of immersion apparatus. Also the extractors can be used for immersion liquids other than water. The extractors can also be used in so-called "leaky seal" liquid supply systems. In such liquid supply systems liquid is provided to the space between the final element of the projection system and the substrate. That liquid is allowed to leak from that space radially outwardly. For example, an immersion hood or fluid confinement system or liquid supply system is used which does not form a seal between itself and the top surface of the substrate or substrate table, as the case may be. The immersion liquid may only be retrieved radially outwardly of the substrate in a "leaky seal" apparatus. The comments made in relation to a single phase extractor may apply to other types of extractor, for example, for example an extractor without a porous member. Such an extractor may be used as a two phase extractor for extracting both liquid and gas.

The present invention will be described in relation to a lithographic apparatus having an immersion system with a liquid handling system and drain as described in the aforementioned figures. However, it will be apparent that the present invention can be applied to any sort immersion apparatus. In particular the present invention is applicable to any immersion lithographic apparatus in which defectivity is a problem which is reduced optimally and desirably minimized. The systems and components described in the earlier passages of the description are thus example systems and components. The invention may apply to other features of the immersion system which include, but is not limited to, cleaning systems and cleaning tools for in-line and off-line implementations; the water supply and water retrieval systems such as an ultra pure water supply system; and the gas supply and removal systems (e.g. a vacuum pump). In particular the present invention is applicable to any immersion lithographic apparatus in which defectivity is a problem which it is desired to alleviate and so minimize.

The present invention will be described below in relation to an immersion system optimized for supplying an immersion liquid. However, the present invention is equally applicable for use with an immersion system that uses a fluid supply system supplying a fluid other than a liquid as the immersion medium.

In immersion lithographic systems contamination, especially organic contamination, may build up. This influences the number of defects in a pattern formed on a substrate. The functionality of immersion lithographic systems, such as meniscus stability of the single phase extractor, may be influenced by contaminant aggregation. A variety of different methods are being developed to clean the immersion systems to remove the contamination with a minimal down time. Some of these techniques, for example, require cleaning chemicals that have a number of drawbacks which may impact on damage to the immersion system, tool design, safety, cleaning time (for example because of rinsing).

Cleaning using a flow of radicals generated by a plasma radical source, may remove most, if not substantially all, organic materials on the surface being cleaned. Such cleaning may be referred to as plasma cleaning or atmospheric plasma cleaning. However, the cleaning is not selective. Furthermore, immersion systems have many sensitive components. The use of plasma technology to clean an immersion system, especially in-line, for example, installed within a lithographic apparatus so that cleaning can take place without removing one or more components, has previously been considered unfavorable because of all the potential damage risks.

In the present invention atmospheric plasma techniques may be used to clean a contaminated surface. Unexpectedly, if conditions are carefully selected, for example, using at least one damage limitation measure it has been found that atmospheric plasma cleaning may be used successfully in a complex immersion lithographic environment.

The plasma may generate an activated species that may be directed in a gas flow directed towards a contaminated surface. The activated species is a short living radical that is active over a short distance. The plasma may be used to generate radicals in a plasma region. A flow of gas may be provided through a plasma region to generate the radicals that may be used for cleaning. Three dimensional surfaces may be readily cleaned, the activated species flowing over the surface to be cleaned. Surfaces suitable for cleaning include the immersion system and a substrate edge before it is placed on the substrate table. Rinsing may be unnecessary because, apart from the species generated in the plasma, chemicals are not used.

To avoid or reduce damage several strategies can be applied according to the present invention. These include: appropriately selecting a reductive plasma or an oxidative plasma depending on the surface desired to be cleaned, noting that a reductive plasma (i.e. unlike an oxidative plasma) generates radicals which may not damage metals or etch glass; avoiding surfaces sensitive to the radicals; preventing the radicals from accessing some surfaces by using a protective air flow and/or providing a physical barrier to prevent the radicals from reaching sensitive surfaces; using radio frequency generated plasmas, which may result in lower temperature gas flows than other forms of generating a plasma; or supplying a gas flow from which ions have been removed and/or which only provides a flow of radicals. In an example, a flow of gas, at a temperature of below 60 degrees Celsius, onto a surface may remove 100 to 200 nm of contaminants per minute. Furthermore, temperature effects may be reduced by using short contact times on a surface or pulsing the plasma radical source.

The cleaning technique may be a simple and fast method enabling mainly organic contamination to be removed, including from sensitive surfaces. The method may be used to remove resist like contamination and other types of contamination which may be difficult to remove (for example partly carbonized contamination).

The cleaning technique may use radicals generated from oxygen (oxidative plasma) or hydrogen (reductive plasma) in an inert gas. The inert gas may be, for example, nitrogen or a nobel gas, such as neon, argon, xenon or helium. The inert gas may be mixed with an active gas. The active gas may be hydrogen or oxygen. In an embodiment of oxidative plasma, the inert gas may be mixed with, or may be, air.

In order to generate the radicals, the gas, including a combination of an inert gas and an active gas may be passed through a plasma generating region in which radicals may be formed from the active gas. The plasma generating region may be part of the plasma radical source. It will be appreciated that the gas source providing the flow of gas to the plasma generating region may be provided at some distance from the plasma generating region.

The plasma generating region may include a high temperature element located within the flow of gas. The temperature of such a high temperature element should be sufficient to cause thermal dissociation in order to create radicals. Such an arrangement may, in particular, be used with a flow of air or purified air in order to provide oxygen radicals for cleaning.

In an alternative arrangement, the plasma generating region may include at least one of an RF coil, a pair of AC or DC discharge electrodes and a microwave or RF cavity that generates a region of plasma within the flow of gas provided from the gas source. Radicals may be formed in the plasma region. In such an arrangement, the concentration of the active gas may be low, for example it may be between approximately 0.5% and approximately 2% of the gas supplied by the gas source. In a particular arrangement, the active gas may be approximately 1% of the gas supplied by the gas source.

In a particular arrangement, a conduit supplies radicals from the plasma radical source to the surface to be cleaned. The plasma radical source and the conduit may be configured such that substantially no ions are provided from the conduit to the surface to be cleaned. In particular, this may be achieved by ensuring that the conduit is sufficiently long that the majority, if not all, of the ions formed in the plasma generating region collide with a surface of the conduit or with other plasma and/or gas species and are therefore removed. Such an arrangement may-be-desirable because the ions may cause damage to the surface to be cleaned. The cleaning apparatus may be arranged to provide a flow of radicals to the surface to be cleaned without including a significant number of ions within the flow.

In a particular arrangement, the plasma generating region may be located between approximately 1mm and approximately 30mm from the surface to be cleaned. The outlet of the conduit may be as close as 0.1mm, for example, from the surface to be cleaned. However a greater distance may facilitate a cleaning process, for example, if the surface to be cleaned has a 3D shape and the conduit outlet is to be scanned above the surface. The arrangement may be selected to provide a sufficient length of conduit for the ions to be removed from the flow or reduced to a desirable level. At the same time, the number of radicals within the flow may not be reduced to below a level at which the cleaning ceases to be sufficiently effective. The desired distance between the plasma radical source and the surface to be cleaned may depend on the design of the conduit, for example the design of the conduit outlet.

It should be noted that, where sensitive surfaces are to be cleaned, such as stickers, and coatings comprising organic or metal oxides, a reductive plasma may be preferred to an oxidative plasma. A reductive plasma does not cause oxidative damage. A suitable reductive plasma comprises hydrogen.

The temperature of the gas flow when it is applied to the surface to be cleaned may be between 50-100° C. If an RF source is used to generate a plasma, the gas flow applied to the surface may, for example, be approximately 60° C. If a thermal source is used to generate a plasma, the temperature of the gas flow applied to the surface may be approximately 100° C.

Accordingly, the use of an RF source may be beneficial because the temperature of the gas flow applied to the surface to be cleaned maybe lower, reducing the heating on the surface. This may be beneficial because heat loads on a sensitive surface within an immersion lithographic apparatus may result in damage. Alternatively or additionally, once the cleaning process is completed, if there has been significant heating of any components, it may be necessary to wait until the components have cooled before lithography processing can be resumed. Accordingly, heating of components within the lithographic apparatus may result in additional loss of exposure processing time beyond the time required to perform the cleaning process.

It should be appreciated that the temperature of the gas flow provided to the surface to be cleaned may be higher if a thermal source is used to generate a plasma than if an RF source is used. However, the gas flow in that case may include a larger number of radicals than if an RF source is used. Accordingly, the time for which the gas flow must be provided to a surface in order to remove a required amount of contaminants may be lower than the time that would be required for a radical cleaning process using an RF source. Accordingly, by applying a higher temperature gas flow for a smaller amount of time, the total heat load applied to the surface during the cleaning process may be the same or smaller.

Regardless of the means used to generate the flow of radicals for cleaning, it will be appreciated that the amount of time that the gas flow is applied to the surface to be cleaned should be minimized. Thus, the surface to be cleaned may not be warmed up dramatically. With a short effective contact time per unit area, the heat load may be minimal, minimizing the possible damage that could be caused to the surface.

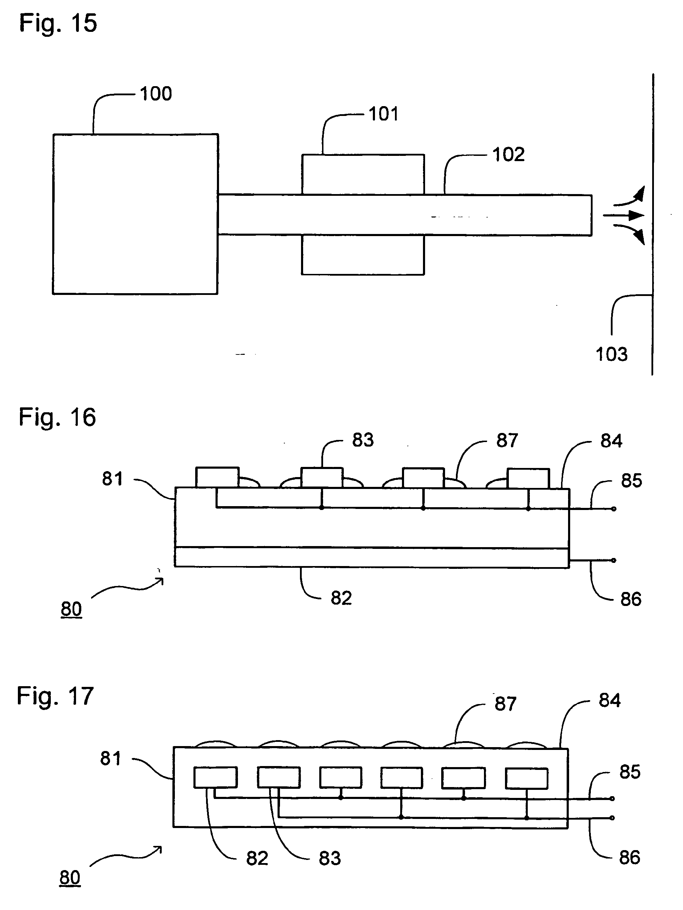

Figure 15 schematically depicts a source of radicals that may be used as part of a cleaning apparatus of the invention. As shown, a gas source 100 provides a flow of gas that passes through a plasma generating region 101 in which radicals may be formed and is directed by a conduit 102 onto a surface 103 to be cleaned. As discussed above, the plasma generating region 101 may include at least one of a high temperature element located within the flow of gas, an RF coil, a pair of AC or DC discharge electrodes and a microwave or RF cavity.

The active gas is active only in a limited space due to the short lifetime of the radicals. Therefore, the conduit outlet may be located between approximately 1 mm and approximately 30 mm from said surface to be cleaned. More desirably, the distance between the surface and the conduit outlet may be in the range of approximately 10 mm to 20 mm.

The cleaning apparatus according to the present invention, may, in particular, be a so-called atmospheric plasma cleaner. It may also be referred to as a plasma cleaner. In such an arrangement, the flow of gas from the plasma cleaner, including the radicals which are to be used for the cleaning process, is output into a space at substantially atmospheric pressure. In particular, therefore, the space does not need to be evacuated. Beneficially, therefore, the cleaning apparatus may be used with minimal preparation time because, for example, it is not necessary to evacuate a space before the cleaning process can commence. It will be appreciated that the gas supply providing a flow of gas to the plasma cleaner should provide the gas at a higher pressure than the pressure of the space in which the plasma cleaner is operating.

The present invention may be a cleaning apparatus configured to clean a substrate or component of an immersion lithographic apparatus. The immersion lithographic apparatus may comprise a substrate table and a fluid confinement system. The substrate table may support a substrate. The fluid confinement system may confine immersion fluid between a projection system and substrate table, a substrate or both. The cleaning apparatus may comprise: a plasma radical source, a conduit and a radical confinement system. The plasma radical source provides a flow of radicals. The plasma radical source may be configured to supply a source of reducing radicals or oxidizing radicals. The plasma radical source may be configured to remove ions from the flow of radicals. Desirably, radicals are the only active component supplied by the radical flow. The conduit is configured to supply radicals from the plasma radical source to the surface to be cleaned. The radical confinement system is configured to direct the radicals to clean a localized portion of said surface.

Since the radicals are directed at a localized portion of a surface to be cleaned, the radicals are directed at a single portion for a short duration of time. This is to enable different portions of the surface to be cleaned. Thus the portions may be changed so that substantially the whole surface can be cleaned. A short contact time is desirable because the surface to be cleaned does not warm up significantly, minimizing the risk of damage to the surface.

The radical confinement system may comprise a barrier member. Accordingly, the flow of radicals to sensitive components may be prevented or restricted. The radical confinement system may be configured to provide a flow of gas to the localized portion of the surface, for example away from sensitive components. The radical confinement system may be configured to provide the flow of gas so as to limit the radicals substantially to the same side of the barrier member as said localized portion of said surface. The barrier member may be a radical confinement chamber within which an outlet of said conduit is located. Accordingly, the radicals may be contained within the chamber, preventing or reducing their flow to sensitive components that may be located outside the chamber.

The radical confinement chamber may comprise an outlet connected to an under pressure source. Accordingly, the pressure within the radical confinement chamber may be lower than the surrounding region of the lithographic apparatus. At a gap that may exist between an edge of the radical confinement chamber and the surface to be cleaned, gas will tend to flow into the radical confinement chamber. The flow of any radicals from within the radical confinement chamber to outside of the radical confinement chamber where sensitive components of the lithographic apparatus may be located, may be reduced or prevented.

The radical confinement system may be specifically configured to form a gas flow to direct the radicals. In particular, the radical confinement system may include a gas outlet and a gas exhaust. The radical confinement system may be arranged such that the gas outlet provides a flow of gas towards a portion of the surface to be cleaned on which the flow of radicals from the conduit is directed. The flow of gas is directed so as to prevent the flow of radicals from the conduit flowing towards a different part of the surface that may, for example, include sensitive components. The gas exhaust may be arranged to extract gas, for example gas flowing from the conduit of the cleaning apparatus after it has been directed towards the surface to be cleaned and/or gas provided by the gas outlet of the radical confinement system. It will be appreciated, however, that a dedicated gas exhaust may not be required.

The following description refers to exemplary embodiments of a plasma cleaner 42 or a cleaning apparatus for a surface of the immersion system. The specific embodiments described relate to plasma cleaners for a fluid confinement structure 12 (also known as an immersion hood) and a substrate table WT. Each of them may embody a cleaning apparatus previously described.

The plasma cleaner 42 may have a volume of less than a litre, more desirably, less than 0.5 litres, enabling it to be readily fitted to a lithographic apparatus. The plasma cleaner 42 may be used in off-line embodiments or in-line embodiments, may be used to clean a surface within a lithographic apparatus without removing one or more components of the lithographic apparatus and/or without suspending the use of the lithographic apparatus for exposures for a significant amount of time. Alternatively or additionally, it may be used to perform cleaning processes while the use of the lithographic apparatus is suspended.

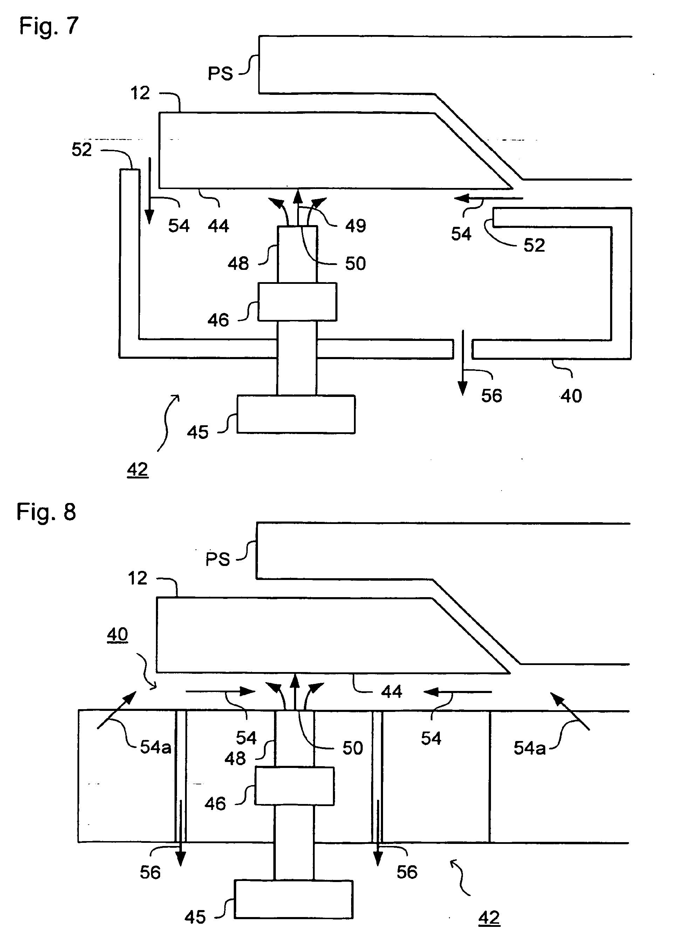

The plasma cleaner 42 may be mounted under the fluid confinement structure 12 to clean a surface of the liquid confinement structure 12 such as its undersurface 44, as shown in Figure 7. This may be an off-line embodiment. In an in-line embodiment, the plasma cleaner 42 may be located in a sensor recess or designated station located in the substrate table WT, as shown in Figure 8.

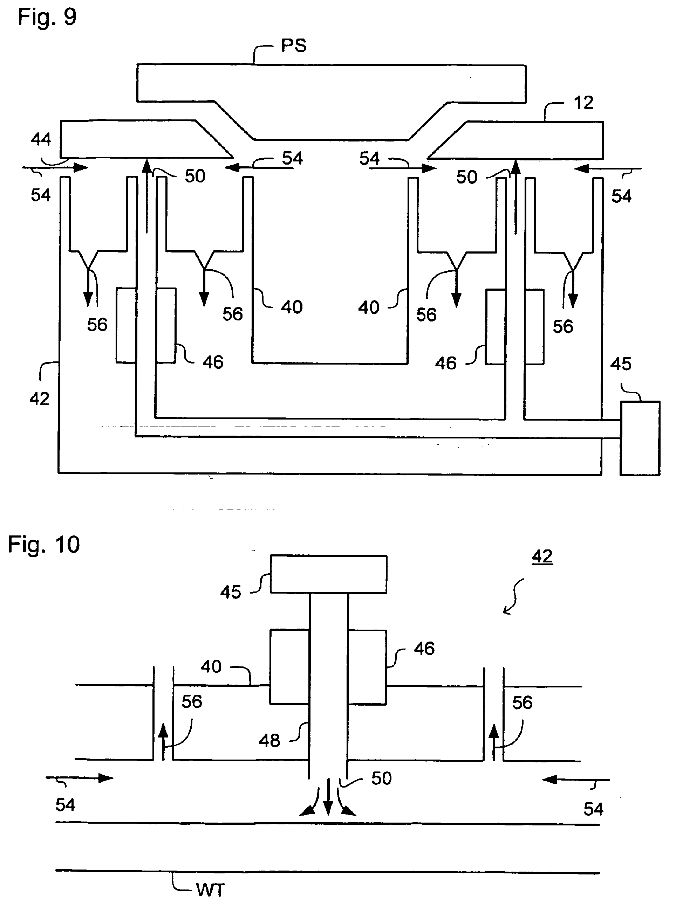

Figure 9 shows a rotatable plasma cleaner 42 for cleaning the undersurface 44 of the fluid confinement structure 12. This may be implemented in an in-line embodiment or an off-line embodiment as shown in Figures 7 and 8. The plasma cleaner 43 may be mounted to an immersion lithographic apparatus to clean the surface of a substrate table WT, as shown in Figure 10. This may be an in-line or an off-line implementation. In a variation of this embodiment, the plasma cleaner 42 may be integrated into a fluid confinement structure 12, so that for an outlet 50 of a plasma cleaner conduit 46 may be directed to a localized surface of the substrate table WT.

As explained above, a cleaning apparatus according to the present invention may be installed in an immersion lithographic apparatus. Such an apparatus may in particular comprise a projection system, an immersion fluid confinement structure and a substrate table for supporting a substrate. The projection system may be configured to impart a patterned beam onto a substrate. The immersion fluid confinement structure may be configured to confine an immersion fluid between the projection system and the substrate or a substrate table. The cleaning apparatus may be have the features of a plasma cleaner as previously described and may be arranged to clean a localized portion of a surface of the fluid confinement structure. The cleaning apparatus may be an integral part of the immersion lithographic apparatus.

The cleaning operation may occur while the fluid confinement_structure is installed within the immersion lithographic apparatus. The radical confinement system of the cleaning apparatus may, in particular, be configured to prevent radicals from being directed onto an element of the projection system. This may be important because the elements of the projection system may be susceptible to damage by a plasma cleaner and any such damage may degrade the performance of the projection system.

The substrate table may be configured such that the substrate table can be removed from the region adjacent the fluid confinement structure and the projection system. When the substrate table is removed from said region, the cleaning apparatus may be operable to clean said localized portion of a surface of the fluid confinement structure.

In one configuration, the plasma cleaner may be mounted to an actuator system. The plasma cleaner may be arranged such that it can advance to the surface to be cleaned of the fluid confinement structure. The plasma cleaner may be moved towards the fluid confinement structure once the substrate table is removed from the region adjacent the fluid confinement structure.

Alternatively or additionally, for example, at least an outlet of said conduit of the cleaning apparatus may be installed within the substrate table. Accordingly, the cleaning apparatus may be moved relative to the fluid confinement structure by movement of the substrate table. The cleaning apparatus may, for example, be installed within the substrate table in a location such that, when the substrate table is supporting a substrate, the substrate is located on top of the cleaning apparatus. Accordingly, when the substrate table is supporting a substrate the cleaning apparatus does not interfere with the normal operation of the immersion lithographic apparatus. However, when the substrate table is not supporting a substrate, the substrate table may be moved as required to position the cleaning apparatus as necessary to clean a desired portion of a surface of the fluid confinement structure. In another embodiment, the cleaning apparatus may be located in the substrate table away from the location of the substrate table that supports the substrate. Such a location may be an opening in the substrate table for a sensor.

The immersion fluid confinement structure may surround an element of the projection system. The cleaning apparatus may be configured to clean a band on a surface of the immersion fluid confinement structure that may surround said element of the projection system. Said band may be an annular region of the surface of the immersion fluid confinement structure. The outlet of the conduit supplying said radicals may be configured to conform to the shape of said band to be cleaned. One or more plasma radical sources may be arranged to provide radicals to said conduit.

Figure 7 depicts an embodiment of a cleaning apparatus 42 for cleaning a surface of a fluid confinement structure 12 which may, in particular, be off-line. In operation, a gas flow from a gas source 45 may pass through a plasma radical source 46. The plasma radical source 46 may be located in a plasma head in which a region of plasma is generated as discussed above. The gas flow may entrain radicals generated by the plasma radical source 46. The gas flow may pass through a conduit 48. The conduit 48 may direct the gas flow to a localized under surface 44 of the fluid confinement structure 12 being cleaned. In this way at least one of the gas knife extractor, gas knife and single phase extractor may be cleaned. As described above, the conduit may be configured to be sufficiently long so as to remove ions from the gas flow before the gas flow is used for cleaning. If ions are present in the gas flow, the ions may damage the surface being cleaned.

The conduit 48 may have an outlet 50 by which the gas flow 49 is directed to the localized surface. The outlet 50 may be positioned 5 to 20 mm from the surface being cleaned. The outlet 50-may be-located in a radical confinement system 40.

The radical confinement system 40 may comprise a chamber which may enclose the environment in which the cleaning apparatus operates. One or more edges 52 of the radical confinement system 40 may act as a barrier member to restrict the flow of the plasma generated radicals over the surface of the fluid confinement structure 12 by physically blocking the flow.

Additionally or in the alternative, a gas flow 54 between one or more of the edges 52 and the fluid confinement structure 12 may be used to restrict the radicals to a localized surface of the fluid confinement structure 12. The gas flow 54 may limit the radicals substantially to the same side of the barrier member as said localized portion of said surface. The chamber may comprise one or more outlets 56 connected to an under pressure source to extract gas from the chamber and to control the flow of the radicals.

It will be appreciated that the provision of the under pressure source, extracting gas from the chamber may be sufficient to lower the pressure within the chamber below the pressure in the remainder of the immersion lithographic apparatus. Accordingly, the pressure difference established by the under pressure source connected to the outlet 56 may establish the gas flow 54 between the one or more edges 52 of the chamber and the fluid confinement structure 12. Alternatively or additionally, separate gas sources may be provided having appropriately placed outlets in order to establish the gas flow 54. Together these features act as an active lens cover. Any impact of active species on the final element of the projection system PS which may be adjacent the immersion confinement structure may thus be avoided. Additionally or alternatively, a passive; physical lens cover may also be used.

In an off-line embodiment, the cleaning apparatus 42 may be mounted to the immersion system using the three connection points, which may be near the final element of the projection system PS. In such an arrangement the substrate table WT is removed from the immersion lithographic apparatus first or, at least, moved away from the projection system.

The cleaning apparatus 42 may, as described above, be arranged such that the outlet 50 of the conduit is annular, e.g. ring-shaped, such that it may simultaneously clean a band, for example an annular band, on the surface of the fluid confinement structure. This may be beneficial because contaminants on the fluid confinement structure may, in particular, build up on such an annular band. The annular band may correspond to the location of a component of the fluid confinement structure, for example, porous member 21.

Alternatively or additionally, the components of the cleaning apparatus 42 may be mounted to an actuator system or to the substrate table such that the outlet 50 of the conduit 48 may be moved to the required locations to clean at least a part of the surface of the fluid confinement structure 12. In such an arrangement, the outlet 50 of the conduit 48 may be relatively small. This may permit the use of a smaller plasma generating region but may require the cleaning apparatus 42 to be moved in order to clean all of the areas of the under surface 44 of the fluid confinement structure 12 that require cleaning. The actuator system and/or substrate table may be connected to a controller. Thus, the cleaning apparatus may be controlled to select the surface of the confinement structure to be cleaned.

Alternatively or additionally, components of the cleaning apparatus 42 may be configured to rotate about an axis. The outlet 50 of the conduit 48 may be rotated through part of or a complete revolution of 360 degrees in order to provide cleaning to part of or substantially all of an annular band on the under surface 44, for example the surface of the porous member 21. The cleaning apparatus may be connected to a controller arranged to control the rotation of the cleaning apparatus. Thus, by operating the controller, the surface cleaned may be selected.

The complete undersurface 44 of the fluid confinement structure 12 may be cleaned by any or all of the means discussed above.

In an embodiment, a reductive plasma may be used to generate the radicals so as to avoid oxidation of features such as the single phase extractor and coatings. The contact time may be limited to avoid damage caused by over-heating of some features.

Such off-line atmospheric plasma cleaning may take a shorter duration than other known off-line cleaning techniques. Desirably, such off-line atmospheric plasma cleaning may be considered a rapid off-line method.

Figure 8 depicts an embodiment of a cleaning apparatus 42 that may in particular be used for in-line cleaning of surfaces of the fluid confinement structure and/or components associated with it, such as surfaces of sensors. The embodiment shown has similar features as the embodiment shown in Figure 7. Variants discussed above in relation to Figure 7 may be applied to the arrangement depicted in Figure 8.

The cleaning apparatus may be located in a portion of the substrate table WT, such as a cleaning station. The fluid confinement structure 12 may be moved relative to the substrate table WT so that it located above the conduit outlet 50. The cleaning apparatus 42 may have a radical confinement system 40 defined by a portion of the substrate table WT, but it might not have a chamber. The radical confinement system 40 may have a protective gas flow 54 to prevent the radicals from flowing over sensitive areas of the immersion system such as on the fluid confinement structure 12, or a lens of the projection system, as illustrated in the figure. The radical confinement system 40 may have one or more outlets 56 connected to an under pressure source in order to extract the radicals and to control the flow of the radicals.

As with the arrangement discussed above in relation to Figure 7, the under pressure source 56 may also be arranged such that it results in the space adjacent the cleaning apparatus 42 having a lower pressure than the space in the remainder of the immersion lithographic apparatus. The protective gas flow 54 results. Alternatively or additionally, the cleaning apparatus 42 may comprise one or more outlets 54a connected to a gas source that are specifically configured to provide the protective gas flow 54. Such an arrangement may be particularly beneficial if it is not possible to provide a chamber to limit the flow of radicals from the area to be cleaned.

Figure 9 depicts an embodiment of part of a cleaning apparatus 42 according to the invention, located underneath a fluid confinement structure. The embodiment may be an off-line embodiment as shown in Figure 7 where the cleaning apparatus is fitted to the projection system PS, the fluid confinement structure 12 or both. Alternatively or additionally, the embodiment of Figure 9 may be implemented in an in-line embodiment in which the cleaning apparatus 42 may be in a cleaning station. Variants discussed above in relation to Figures 7 and 8 may be applied to the arrangement depicted in Figure 9.

In the embodiment, the cleaning apparatus 42 may rotate, for example, about the optical axis of the projection system PS so that the undersurface 44 of the fluid confinement structure 12 and/or other components associated with it is cleaned. The cleaning apparatus 42 may have at least two radical confinement systems 40, each having a chamber in which may be located a conduit outlet 50. Each conduit outlet 50 may be associated with a separate plasma generating region 46, as depicted in Figure 9. Alternatively, one or more conduit outlets 50 may be supplied with radicals by a common plasma generating region 46.

The cleaning apparatus may comprise a single conduit outlet 50 and a single radical confinement system. The cleaning apparatus may be configured, for example, such that it can be rotated 360 degrees about the optical axis of the projection system. In general, the larger the number of conduit outlets 50 that the cleaning apparatus has, the less the cleaning apparatus 42 needs to rotate in order to provide a clean band of the under surface 44 of the fluid confinement structure 12 that completely surrounds the optical axis of the projection system PS. Each chamber may be connected to an under pressure source via one or more outlets 56. Thus, during cleaning, there is a gas flow into the chambers restricting the flow of the radicals to the localized surface being cleaned during cleaning.

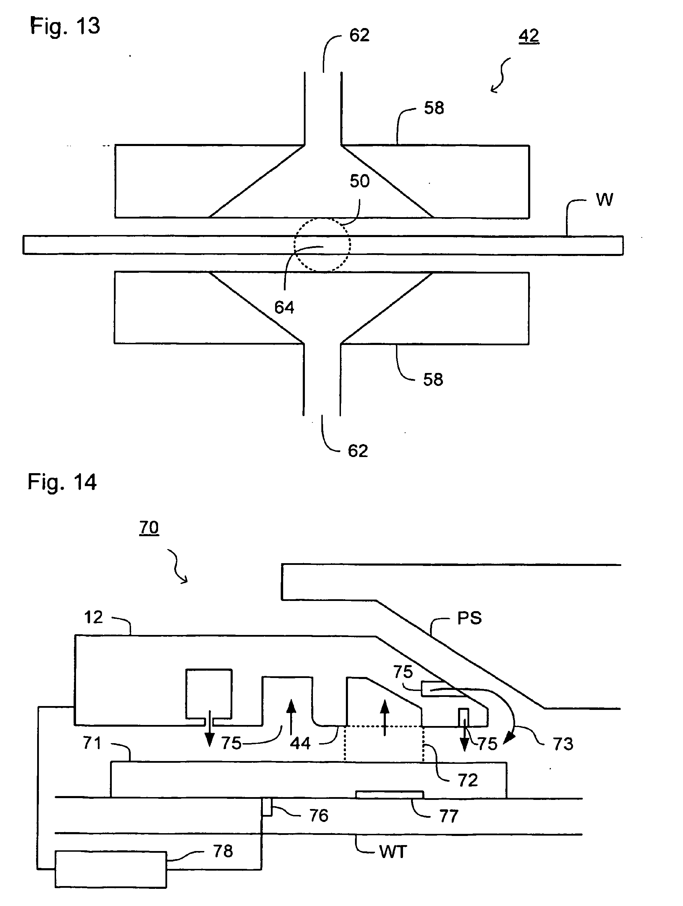

Figure 14 depicts an alternative arrangement for cleaning the under surface 44 of the fluid confinement structure 12. In this arrangement, the cleaning apparatus 70 includes a main body 71 that is configured such that it may be mounted on the substrate table WT. In particular, the main body 71 may comprise a round plate having the same external diameter as a substrate such that the substrate table WT can support the main body 71 of the cleaning apparatus 70 in the same manner as it supports a substrate without any modification.

The main body is formed from an insulating material and has one or more electrically conducting regions 77 located on the surface of the main body 71 that faces away from the fluid confinement structure 12.

A voltage difference, supplied by a voltage supply 78, is established between the at least one electrically conducting_region 77 and at least a part of the fluid confinement structure 12, creating a plasma generating region 72 in the portion of the region between the main body 71 and the fluid confinement structure 12 that is adjacent to the at least one electrically conducting region. The at least one electrically conducting region 77 may be shaped to conform to the shape of a part of the fluid confinement structure 12 to be cleaned.

The voltage required to establish the plasma generating region may depend on the thickness of the main body 71 and, in particular, the separation between the main body and the fluid confinement structure 12. The voltage required may, for example, be between about 50 and 300 V. A varying voltage should be used, such as an AC voltage having a sin wave form. However other voltage patterns may also be used. In addition, the voltage may be pulsed, providing time periods in which no voltage is provided. This may reduce heating.

The cleaning apparatus 70 does not include its own gas source to be passed through the plasma generating region 72. Instead, the fluid confinement structure 12 of the immersion lithographic apparatus may be configured to provide the flow of gas which includes a mixture of inert gas and an active gas, as described above. For example, the fluid confinement structure 12 may be configured such that, in a cleaning operation, it is drained of immersion liquid. Subsequently, the gas flow is provided-by-one or more components of the fluid confinement structure 12 and is supplied to the plasma generating region 72 in order to create the radicals. The fluid confinement structure components may be used during an exposure process to provide and/or control the immersion liquid.

Alternatively or additionally, the fluid confinement structure 12 may be provided with separate conduits specifically for supplying and/or controlling the flow of gas during a cleaning operation.

The flow of gas provided during the cleaning operation is configured such that it flows through the plasma generating region 72, the location of which may be defined by the location of the at least one electrically conducting region 77, resulting in the generation of radicals in the region in which cleaning is required.

The flow of gas 73 provided to the plasma generating region 72 by the fluid confinement structure 12 may be configured such that the flow of gas also functions to confine the radicals that are generated. In particular, as shown in Figure 14, the flow of gas 73 may be arranged to flow from one or more gas inlets providing gas from the fluid confinement structure 12 to the space between the fluid confinement structure 12 and the main body 71 of the cleaning apparatus 70. The gas flow 73 may be extracted from one or more fluid outlets 75 in the fluid confinement structure 12. By the appropriate arrangement of the gas inlets 74 and fluid outlets 75, the gas flow 73 may be configured to flow away from the final element of the projection system PS. This ensures that the flow of radicals back to the projection system PS is prevented or significantly reduced when radicals are generated in the plasma generating region 72. By appropriate modification, a similar system may be used to prevent radicals flowing onto other sensitive components.

Power may be supplied to the cleaning apparatus 70 by means of one or more electrodes mounted on the substrate table WT. For example, one or more of the pins 76 of the substrate table, that are used to lift a substrate relative to the substrate table WT in order to enable the substrate to be removed from the substrate table WT, may be connected to an electrical power source. Correspondingly, one or more electrodes may be provided on the under surface of the main body 71 of the cleaning apparatus 70 and connected to the one or more electrically conducting regions 77. The one or more electrodes may be arranged such that the electrical contacts of the cleaning apparatus are in contact with the electrical contacts of the substrate table when the cleaning apparatus 70 is mounted to the substrate table WT. Actuation to achieve the arrangement may be achieved by operation of a controller.

In addition to radicals, ions may be created in the plasma generating region 72. The damage that may be caused by any such ions may be reduced by controlling the energy of any such ions. This may be achieved, for example, by appropriate selection of the gas and the voltage provided between the at least one electrically conducting region 77 and the fluid confinement structure 12.

An arrangement such as that depicted in Figure 14, in which the cleaning apparatus may be loaded to the lithographic apparatus for a cleaning process in the same manner as a substrate, may provide a convenient arrangement for rapid cleaning of the under surface 44 of the fluid confinement structure 12. Significant redesign of the immersion lithographic apparatus may not be required. Significant time required to re-configure an immersion lithographic apparatus for the performance of a cleaning process may be avoided. It should be appreciated that although the arrangement depicted in Figure 14 has been described above in the context of inline cleaning, for example cleaning at least a part of the lithographic apparatus without opening the lithographic apparatus, the arrangement may also be used for cleaning at least a part of the lithographic apparatus offline.

Figures 16 and 17 depict arrangements that may be used to provide cleaning. These arrangements are similar to that which is discussed above in relation to Figure 14 and, accordingly, only the differences will be discussed. It should be appreciated that variations of the arrangements discussed above in relation to Figure 14 may also apply to the arrangements depicted in Figures 16 and 17. In particular, the arrangements depicted in Figures 16 and 17 and described below may be used for either inline or offline cleaning.

As with the arrangement discussed above in relation to Figure 14, the arrangements depicted in Figures 16 and 17 provide a cleaning apparatus that has a main body 81 that is configured such that it may be mounted on the substrate table WT. In particular, the main body 81 may comprise a round plate having the same external diameter as a substrate such that the substrate table WT can support the main body 81 of the cleaning apparatus 80 in the same manner as it supports a substrate without any modification. The main body 81 is formed from an insulting material, for example Al₂O₃.

As with the arrangement depicted in Figure 14, the cleaning apparatus 81 includes a plurality of electrically conducting regions 82, 83. However, the cleaning apparatus 81 of the arrangements depicted in Figures 16 and 17 have two sets of one or more electrically conducting regions 82, 83, each set being connected to associated electrodes 85, 86. A voltage difference may be applied to the electrodes 85, 86, resulting in the establishment of a plasma 87 on the surface 84 of the main body 81 that faces the under surface 44 of the fluid confinement structure 12 and the projection system PS.

It should be appreciated that any convenient arrangement for connecting the electrodes 85, 86 of the cleaning apparatus 80 to a voltage supply maybe used. In particular, although not depicted in Figures 16 and 17, the electrodes 85, 86 may be mounted onto the surface of the main body 81 that is supported by the substrate table WT. Accordingly, electrical contacts may be provided on the substrate table WT such that they come into contact with the electrodes 85, 86 in order to provide the voltage difference to the cleaning apparatus 80.

It should also be appreciated that the voltages applied to the cleaning apparatus 80 may be different to those provided to the cleaning apparatus 70 depicted in Figure 14. In particular, a voltage difference of several kV may be used. This may enable the cleaning apparatus 80 to be used with a greater range of gases, namely may be used with gases having a higher ignition voltage.

As shown in Figure 16, the cleaning apparatus 80 may have one or more first electrically conducting regions 82 on a side of the main body 81 that faces away from the fluid confinement structure 12 and/or the projection system PS. Accordingly, the one or more first electrically conducting regions are electrically isolated from the side of the main body 81 facing the fluid confinement structure 12 and/or projection system PS.

The second set of electrically conducting regions 83 may be formed on the surface 84 of the main body 81 that faces the fluid confinement structure 12 and/or the projection system PS. Although not depicted in Figure 16, the one or more first electrically conducting regions 82 may be covered by a layer of electrically insolating material.

Alternatively, as depicted in Figure 17, the cleaning apparatus 80 may be configured such that the first and second regions of electrically conducting material 82, 83 are embedded within the main body 81. Accordingly both sets of electrically conducting regions 82, 83 may be electrically isolated from the side of the main body 81 that faces the fluid confinement structure 12 and/or the projection system PS. Both arrangements depicted in Figures 16 and 17 may provide so-called Surface Dielectric Barrier Discharge (SDBD).

One of the advantages of a cleaning apparatus 80 as depicted in Figures 16 and 17 is that the plasma 87 may be generated without providing a voltage difference between the cleaning apparatus 80 and the surface to be cleaned, for example as is required for the arrangement depicted in Figure 14. Accordingly, a cleaning apparatus 80 such as that depicted in Figures 16 and 17 may be used to clean electrically non-conducting materials. Accordingly, for example, the cleaning apparatus 80 depicted in Figures 16 and 17 may be used to clean the surface of a lens of the projection system PS, in particular the surface of the final element or lens of the projection system PS. The final element of an immersion lithographic apparatus may, in particular, require cleaning. For example, if a high NA immersion liquid is used, the liquid may be a hydrocarbon fluid. When UV radiation passes through such a liquid, it may dissociate into carbon and gas. The carbon may coat the surface of the final element and may otherwise be difficult to remove.

The cleaning apparatus 80 as depicted in Figures 16 and 17 may be advantageous because it may be possible to ensure localized cleaning of, for example, the lens. In particular, this may be possible because of one or more of the ability to confine the generated plasma 87 using a flow of gas, the ability to control the region in which the plasma 87 is formed by appropriate arrangement of the regions of electrically conducting material 82, 83 and the ability to control the position of the cleaning apparatus 80 relative to the lens, for example, using the substrate table WT.

During use of the cleaning apparatus 80 depicted in Figures 16 and 17, the surface 84 of the cleaning apparatus 80 may be brought within approximately 0.5 to 2mm from the surface of the lens. With such an arrangement, approximately 4 to 5 µm of contaminant may be removed per minute. Accordingly, it may be possible to clean a lens within a few minutes. Such a cleaning process may be provided periodically. For example. It may be provided regularly or simply when required. In an example, cleaning may be performed between approximately every 15 minutes and every hour.

It should be appreciated that, although the cleaning apparatus 80 depicted in Figures 16 and 17 may be particularly beneficial for cleaning electrically non-conducting components, such as a lens, it may also be used for cleaning other parts of a lithographic apparatus.

The cleaning apparatus may have the features of the cleaning apparatus as previously described and may be arranged to clean a localized portion of a surface of the substrate table and/or components associated with the substrate table, such as surfaces of sensors. For example, in arrangements as discussed above in which the cleaning apparatus is mounted to an actuator system, the actuator system may be arranged such that the cleaning apparatus can be moved between a first position and a second position. In the first position, the cleaning apparatus may clean a surface of the fluid confinement structure 12. In the second position, the cleaning apparatus may clean a surface of the substrate table.

Alternatively or additionally, a dedicated cleaning apparatus may be provided for cleaning a surface of the substrate table. The cleaning apparatus may be configured to clean a localized portion of a surface of the substrate table while the substrate table is installed within the immersion lithographic apparatus. A radical confinement system of the cleaning apparatus may be configured so that a localized portion of the substrate table is cleaned without significant leakage of radicals to other parts of the apparatus. Alternatively or additionally, the substrate table may be removable from a region adjacent the fluid confinement structure and the projection system for a cleaning operation. When the substrate table is removed from said region, the cleaning apparatus may be operarable to clean said localized surface of the substrate table.

Alternatively or additionally, at least an outlet of said conduit of the cleaning apparatus may be installed within the fluid confinement structure. The outlet may be located in a surface of the fluid confinement structure opposing the substrate table.

Figure 10 depicts an embodiment the cleaning apparatus 42 cleaning a localized surface of substrate table WT. The cleaning apparatus 42 may have similar features as the embodiments as shown in Figures 7, 8 and 9. Variants discussed above in relation to those arrangements may be applied to the cleaning apparatus for cleaning the substrate table.

A gas source 45 may supply a gas flow. The gas flow may flow through a plasma generating region 46. The plasma generating region may be part of a plasma radical source 46 and may generate radicals which may be entrained by the gas flow. The gas flow is directed through a conduit 48 to the substrate table WT to clean the localized surface of the substrate table WT. The conduit 48 may have an outlet 50 through which the entraining gas is emitted.

The cleaning apparatus 42 may comprise a radical confinement system 40 having a chamber which may restrict the flow of radicals to the localized surface being cleaned. There may be a protective gas flow 54 between the substrate table WT and the radical confinement system 40, into the chamber. The chamber may have an outlet 56 connected to a source of under pressure which may, for example, establish the protective gas flow 34. This embodiment of the cleaning apparatus may be an off-line implementation in which the substrate table WT is removed from the lithographic apparatus. The cleaning apparatus 40 is then fitted to the substrate table WT to clean the substrate table surface. In a variation, the cleaning apparatus WT may be integral to the fluid confinement structure, so that the conduit outlet 50 may be located in the undersurface of the fluid confinement structure.

Many particles observed during operation of the immersion system may be organic. An important primary source is the substrate edge that carries the organic contamination into the immersion lithographic apparatus. During exposure, the contamination will redistribute over various surfaces of the immersion system and over the substrate surface. Due to this contamination the functionality of several parts of the immersion system, such as the gas knife, the single phase extractor and sensor functionality may be compromised. Therefore it is desirable for the edge region of substrates to be cleaned. Known cleaning methods have been found to have several drawbacks making them difficult to implement and control. For example, physically contacting the substrate can redeposit containing particles on the substrate, contact type cleaners depend on the cleanliness of the cleaning tool and may need replacement; and cleaning techniques using liquids may require drying which is problematic for a substrate.

Using a plasma cleaner to clean a surface of a substrate may encounter a problem. Substrates have an organic coating, such as a resist. Known plasma cleaners do not direct the plasma generated radicals to a specific location as the gas flow from the plasma cleaner tends to broaden and spread to flow across the surface being cleaned. Thus there is a risk that the radicals will clean the substrate surface and remove previously created features on the substrate surface. Alternatively or additionally, the characteristics of as yet unexposed layers of resist may change if exposed to, for example, the radicals. This may have adverse effects on the imaging process or subsequent processing. It has been found that this problem may be solved by directing the radicals only to parts of substrate surface on which features have not been formed. This may be achieved by a gas flow with a component of direction in opposition to the gas flow that entrains the radicals. In this way the radicals clean only the portion of the substrate required to be cleaned. Desirably, a substrate cleaned by this technique will have an edge with improved defect count density (i.e. defectivity), namely a reduction in defect count density, without the need to have stringent specifications for substrates which are difficult to monitor.

A plasma substrate cleaner 42 may be integrated into an immersion lithographic apparatus, e.g. as part of the wafer handler system, may be part of a stand-alone cleaning apparatus, may be part of a substrate transport system in a wafer fabrication facility and/or may be part of a processing unit that at least one of applies resist to a substrate, heats a substrate, chills a substrate and develops resist on a substrate. The atmospheric plasma cleaner may be used to rapidly remove organic contamination from the bevel and apex area of the substrate W.

The cleaning apparatus may have any of the aforementioned features of the cleansing apparatus previously described, for example for cleaning fluid confinement structures/systems and substrate tables.

The cleaning apparatus may comprise a substrate rotator. The substrate rotator may be configured to rotate a substrate relative to said conduit. Alternatively, at least a part of the cleaning apparatus may be configured to rotate about the substrate. A radical confinement system may be configured to direct the radicals to a localized portion of the periphery of the substrate. So, by rotation of the substrate relative to said conduit, the complete perimeter of the substrate may be cleaned.

The conduit may direct the radicals onto a portion of the edge of the substrate. The conduit may direct the radicals onto a peripheral portion of a major face of the substrate on which devices are to be formed. The radical confinement system may comprise a protective gas source configured to provide a gas-flow in opposition to a flow of radicals from said conduit along at least one major surface of the substrate to limit the extent to which the radicals pass onto said surface of the substrate. The radical confinement system may comprise a gas extractor. The gas extractor may be located between said conduit and said protective gas source. The gas extractor may be arranged to extract radicals from said conduit and gas-flow from said protective gas source.

The cleaning apparatus may comprise a substrate holder configured to hold the substrate. The substrate rotator may be configured to rotate both the substrate holder and substrate relative to said conduit. Alternatively, or additionally, the substrate holder may comprise a substrate mount configured to support the substrate. The substrate rotator may be configured to rotate the substrate relative to the substrate mount. The substrate rotator may be configured to support the substrate during cleaning. The substrate rotator may be configured such that, in one mode it is operable to rotate the substrate relative to the conduit. The substrate rotator may have at least one other mode in which it is operable move the substrate between at least two locations, for example it may include actuators to move the substrate between a cleaning location and a load/unload position.

In a particular arrangement, a lithographic apparatus may comprise a substrate handler and a substrate cleaner. The substrate hander may be configured to position a substrate on a substrate table for supporting the substrate during exposure. The substrate handler may be configured to rotate the substrate prior to positioning the substrate on the substrate table. The substrate cleaner may be configured to clean a localized portion of the substrate surface as the substrate rotates.

The plasma cleaner may comprise a plasma radical source, a conduit and a radical confinement system similar to those discussed above. The plasma radical source may provide a flow of radicals. The conduit may be configured to supply radicals from the plasma radical source to the surface to be cleaned. The radical confinement system may direct the radicals to clean said portion.

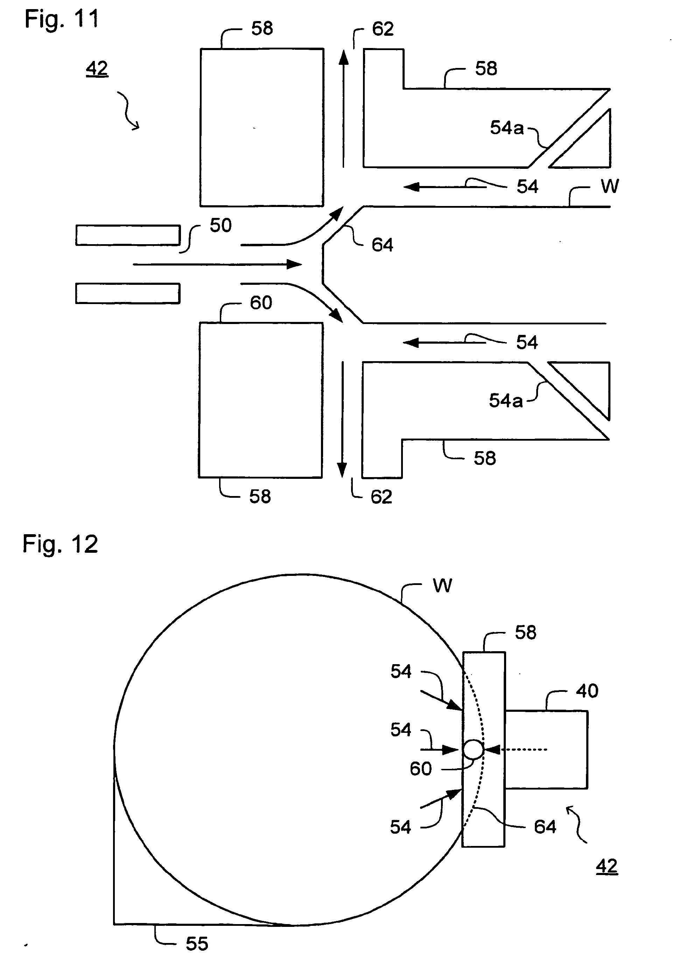

Figure 11 depicts a cross-section through an embodiment of a cleaning apparatus 42 for cleaning an edge 64 of a substrate W; and Figure 12 depicts the same cleaning apparatus and a substrate handler 55 in plan view. This embodiment of the cleaning apparatus has similar features to those shown in Figures 7 to 10, including, but not limited to: a gas source 45, a plasma radical source 46, a conduit 48, a conduit outlet 50 and a radical confinement system 40. Variations discussed above in relation to those arrangements may also be applied to the apparatus depicted in Figures 11 and 12 as appropriate.

In the present embodiment the radical confinement system 40 comprises a substrate enclosure 58 enclosing the portion of the substrate W being cleaned. The substrate enclosure 58 may have an aperture 60 which may be in the form of a slit. The aperture 60 may restrict access of the gas flow entraining the radicals to the peripheral portion of the substrate W, including the edge 64 of the substrate W. Thus the edge region 64 of the substrate W may be cleaned. The enclosure 58 may be configured so that a protective gas flow 54 is directed towards the flow of radicals, parallel to a major surface of the substrate W. The protective gas flow 54 may be sufficient to restrict the radicals to the surface required to be cleaned. The protective gas flow 54, may, for example, be provided by gas conduits 54a within the substrate enclosure 58 that are connected to a gas supply.

At the edge 64 of the substrate W, substantially perpendicular to a major surface of the substrate W may be one or more outlets 62 connected to an under pressure source. In the figure there are two such outlets 62 located in opposite directions. The under pressure may act to remove gas from the substrate enclosure 58, such as exhaust gasses, and draw in the gas entraining the radicals into the substrate enclosure 58. Alternatively or additionally, the under pressure may draw in gas to the space between the substrate enclosure 58 and the substrate W, providing the protective flow of gas 54.

The substrate enclosure 58 may be adjustable, so that it can be accurately positioned relative to the substrate W surface and the conduit outlet 50 so that a sharp clearly defined portion of the substrate surface is cleaned. Adjusting the position of substrate enclosure 58 relative to the surface of the substrate W may ensure that there is no contact between the substrate W and the substrate enclosure 58, especially during rotation of the substrate W, minimizing the risk of damage to the substrate W and/or any features that have already been formed on the substrate W.

Alternatively or additionally, adjusting the separation between the surface of the substrate W and the substrate enclosure 58 may be used to adjust the size of the gap between the, adjusting the flow rate of the protective gas flow 54. This may provide a further tool for adjusting the extent to which the radicals pass over the surface of the substrate W.

During the cleaning process, the cleaner 42 may be held by a substrate rotator. The rotator may rotate, rotating the substrate W about its axis. Accordingly during cleaning, the complete periphery of the substrate W may be cleaned. The rotator may be configured to handle the substrate W to move the substrate between two locations, for example from the substrate stack to a substrate cleaning position, or from the cleaning position to the substrate table WT for exposure, or from the substrate table WT back to the substrate stack.

Figure 13 depicts another view of the embodiment of part of a substrate W and a cleaning apparatus 42 configured to clean the surface of a substrate W. The figure shows the relative positions of the substrate W, substrate enclosure 58, opposing outlets 62 and the conduit outlet 50.

This embodiment may be beneficial because the parts of the wafer to which the plasma generated radicals are not intended to be directed may be shielded and a plume of radicals in the gas flow may be confined or directed.

It should be appreciated that, in addition to cleaning the surface of a substrate, the cleaning apparatus-may also be used to remove contaminants from layers formed on substrates, such as, for example, protective layers or membranes formed on an edge seal on a substrate.

Variations of the described embodiment may achieve the same outcome. The embodiment may be varied in a number of ways. The settings of the plasma source and/or the entraining gas flow (i.e. the speed of the radicals emitted from conduit) may be adjusted. The conduit outlet or substrate enclosure aperture geometry may be altered (e.g. the aperture may have a shape other than a slit). The distance between the surfaces of the substrate and the substrate enclosure may be changed. Note, it may be desirable that substrate surface is as close as possible to the wafer surface (e.g. 100 µm). The distance between the wafer and the edge may be varied depending upon the specific conditions. The under pressure may be varied, as may the flow rate of the protective gas and the geometry and the configuration of the radical confinement system and substrate enclosure.

Using the cleaning apparatus to clean a substrate edge, desirably, there may be no, or minimal, damage to structures on the wafer by uncontrolled radical activity. However the technique may remove resist like contamination within a short time. Surfaces that could be damaged by oxidizing species may be treated with a radicals generated by a reducing plasma, for example with a hydrogen concentration of 1 % hydrogen. The cleaning does not use chemicals that may leave drying stains. The method is contactless, so that there may be no physical damage risk to three dimensional surfaces.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm).

The term "lens", where the context allows, may refer to any one or combination of various types of optical components, including refractive and reflective optical components.

The controllers described above may have any suitable configuration for receiving, processing, and sending signals. For example, each controller may include one or more processors for executing the computer programs that include machine-readable instructions for the methods described above. The controllers may also include data storage medium for storing such computer programs, and/or hardware to receive such medium.

The present invention can be applied to any immersion lithography apparatus, in particular, but not exclusively, those types mentioned above.

One or more embodiments of the invention may be applied to any immersion lithography apparatus, in particular, but not exclusively, those types mentioned above and whether the immersion liquid is provided in the form of a bath, is confined to a localized surface area of the substrate, or is unconfined. In an unconfined arrangement, the immersion liquid may flow over the surface of the substrate and/or substrate table so that substantially the entire uncovered surface of the substrate table and/or substrate is wetted. In such an unconfined immersion system, the liquid supply system may not confine the immersion liquid or it may provide a proportion of immersion liquid confinement, but not substantially complete confinement of the immersion liquid.

A liquid supply system as contemplated herein should be broadly construed. In certain embodiments, it may be a mechanism or combination of structures that provides a liquid to a space between the projection system and the substrate and/or substrate table. It may comprise a combination of one or more structures, one or more liquid inlets, one or more gas inlets, one or more gas outlets, and/or one or more liquid outlets that provide liquid to the space. In an embodiment, a surface of the space may be a portion of the substrate and/or substrate table, or a surface of the space may completely cover a surface of the substrate and/or substrate table, or the space may envelop the substrate and/or substrate table. The liquid supply system may optionally further include one or more elements to control the position, quantity, quality, shape, flow rate or any other features of the liquid.

The immersion liquid used in the apparatus may have different compositions, according to the desired properties and the wavelength of exposure radiation used. For an exposure wavelength of 193nm, ultra pure water or water-based compositions may be used and for this reason the immersion liquid is sometimes referred to as water and water-related terms such as hydrophilic, hydrophobic, humidity, etc. may be used, although they should be considered more generically. It is intended that such terms should also extend to other high refractive index liquids which may be used, such as fluorine containing hydrocarbons.
The descriptions above are intended to be illustrative, not limiting. Thus, it will be apparent to one skilled in the art that modifications may be made to the invention as described without departing from the scope of the claims set out below.

## Claims

1. A cleaning apparatus (42) for cleaning a substrate or component of an immersion lithographic apparatus comprising a substrate table (WT) for supporting a substrate (W) and a fluid confinement system (12) for confining immersion fluid between a projection system (PS) and substrate table and/or substrate, the cleaning apparatus comprising:
a plasma radical source (46) for providing a flow of radicals in a gas flow (49);
a conduit (48) for supplying radicals in the gas flow from the plasma radical source to the surface to be cleaned; and
a radical confinement system (40) for directing the radicals in the gas flow to clean a localized portion of said surface;
wherein the radical confinement system (40) comprises a barrier member; and wherein
the radical confinement system (40) is configured to provide a second flow of gas (54) so as to limit the radicals substantially to the same side of the barrier member as said localized portion of said surface.

2. The cleaning apparatus of claim 1, wherein the barrier member is a radical confinement chamber within which the outlet of said conduit is located and, optionally, the radical confinement chamber comprises an outlet (56) connected to an under pressure source.

3. The cleaning apparatus of claim 1 or 2, wherein at least one of
the plasma radical source is located between approximately 1 mm and approximately 30 mm from said surface to be cleaned;
the radical confinement system is configured to form the second flow of gas to direct the radicals;
the plasma radical source is configured to supply one of a source of reducing radicals and a source of oxidizing radicals; and
the said plasma radical source and said conduit are configured such that substantially no ions are provided from the conduit.

4. The cleaning apparatus of any one of claims 1 to 3, wherein the plasma radical source (46) comprises a gas source (45) and a plasma generating region; and the plasma radical source is configured to supply gas from said gas source so as to pass through said plasma generating region to said conduit (48);
wherein, optionally, the plasma generating region comprises a high temperature element located within the flow of gas, the temperature of the high temperature element being sufficient to cause thermal dissociation to create the radicals; and
optionally, the gas source (45) provides a supply of purified air.

5. The cleaning apparatus of claim 4, wherein the plasma generating region comprises at least one of an RF coil, a pair of AC or DC discharge electrodes and a microwave or RF cavity that generates a region of plasma within the flow of gas from the gas source (45), the radicals being formed in the plasma region;
wherein, optionally, the gas source (45) provides a mixture of an inert gas and an active gas; wherein the inert gas is at least one of nitrogen, helium, argon, neon and xenon; and the active gas is one of oxygen and hydrogen; and
optionally, the active gas is between approximately 0.5% and approximately 2%, and preferably approximately 1% of the gas supplied by the gas source.

6. The cleaning apparatus according to any one of claims 1 to 5, further comprising a rotator, configured to rotate a substrate (W) relative to said conduit (48);
wherein the radical confinement system (40) is configured to direct the radicals to a localized portion of the periphery of the substrate such that, by rotation of the substrate relative to said conduit (48), the complete perimeter of the substrate may be cleaned;
wherein, optionally, said conduit (48) directs the radicals onto a portion of the edge of the substrate (W);
optionally, said conduit directs the radicals onto a peripheral portion of a major face of the substrate on which devices are to be formed;
optionally, said radical confinement system (40) comprises a protective gas source configured to provide a gas-flow (54) in opposition to a flow of radicals from said conduit (48) along at least one major surface of the substrate (W) to limit the extent to which the radicals pass onto said surface of the substrate;
optionally, the radical confinement system (40) comprises a gas extractor (62), located between said conduit and said protective gas source, and arranged to extract radicals from said conduit and gas-flow from said protective gas source;
wherein, optionally, the cleaning apparatus further comprises a substrate holder, configured to hold the substrate (W); wherein the rotator is configured to rotate the substrate holder relative to said conduit;
wherein, optionally, the cleaning apparatus further comprises a substrate mount, configured to support the substrate (W); wherein the rotator is configured to rotate the substrate relative to the substrate mount;
wherein, optionally, the rotator is configured to support the substrate (W) during cleaning; and
wherein, optionally, the rotator is configured such that, in one mode it is operable to rotate the substrate (W) relative to the conduit (48) and, it has at least one other mode in which it is operable move the substrate between locations.

7. A cleaning apparatus according to claim 6, installed within one of a lithographic apparatus, a transport unit configured to transport a substrate (W), and a substrate processing unit configured to at least one of coat a substrate with a resist, bake a substrate, cool a substrate and develop a layer of resist on a substrate that has been exposed with a patterned beam of radiation.

8. An immersion lithographic apparatus comprising:
a projection system (PS) for imparting a patterned beam onto a substrate (W);
a fluid confinement structure (12) for confining immersion fluid between the projection system and the substrate and/or a substrate table (WT), the substrate table for supporting a substrate; and
a cleaning apparatus (42) according to any one of claims 1 to 5, arranged to clean a localized portion of a surface of the fluid confinement structure (12).

9. An immersion lithographic apparatus comprising:
a projection system (PS) for imparting a patterned beam onto a substrate (W);
a substrate table (WT) for supporting the substrate;
a fluid confinement structure (12) for confining immersion fluid between the projection system (PS) and the substrate and/or the substrate table; and
a cleaning apparatus (42) according to any one of claims 1 to 5, arranged to clean a localized portion of a surface of the substrate table.

10. A lithographic apparatus comprising:
a substrate handler configured to position a substrate (W) on a substrate table (WT) for supporting the substrate during exposure, the substrate handler configured to rotate the substrate prior to positioning the substrate on the substrate table; and
a cleaning apparatus (42) according to any one of claims 1 to 5, configured to clean a localized portion of the substrate surface as the substrate rotates.

11. A method for cleaning a substrate or component of an immersion lithographic apparatus, the immersion lithographic apparatus comprising a substrate table (WT) for supporting a substrate (W) and a fluid confinement structure (12) for confining immersion fluid between a projection system (PS) and substrate table and/or substrate, the method comprising:
providing a flow of radicals in a gas flow (49) using a plasma radical source (46);
supplying radicals in the gas flow from the plasma radical source (46) to the surface to be cleaned using a conduit (48); and
directing the radicals in the gas flow to clean a localized portion of said surface using a radical confinement system (40);
wherein the radical confinement system comprises a barrier member and the method further comprises:
providing a second flow of gas (54) so as to limit the radicals substantially to the same side of the barrier member as said localized portion of said surface.

## Patentansprüche

1. Ein Reinigungsgerät (42) zum Reinigen eines Substrats oder einer Komponente eines immersionslithographischen Geräts, das einen Substrattisch (WT) zum Stützen eines Substrats (W) und ein Fluideingrenzungssystem (12) zum Eingrenzen von Immersionsfluid zwischen einem Projektionssystem (PS) und einem Substrattisch und/oder Substrat beinhaltet, wobei das Reinigungsgerät Folgendes beinhaltet:
eine Plasmaradikalquelle (46) zum Bereitstellen einer Strömung von Radikalen in einer Gasströmung (49);
eine Leitung (48) zum Zuführen von Radikalen in der Gasströmung von der Plasmaradikalquelle zu der zu reinigenden Oberfläche; und
ein Radikaleingrenzungssystem (40) zum Lenken der Radikale in der Gasströmung, um einen örtlich begrenzten Abschnitt der Oberfläche zu reinigen;
wobei das Radikaleingrenzungssystem (40) ein Absperrungsteil beinhaltet; und wobei das Radikaleingrenzungssystem (40) konfiguriert ist, um eine zweite Strömung von Gas (54) bereitzustellen, so dass die Radikale im Wesentlichen auf dieselbe Seite des Absperrungsteils beschränkt werden wie der örtlich begrenzte Abschnitt der Oberfläche.

2. Reinigungsgerät gemäß Anspruch 1, wobei das Absperrungsteil eine Radikaleingrenzungskammer ist, innerhalb der sich der Auslass der Leitung befindet, und die Radikaleingrenzungskammer wahlweise einen Auslass (56) beinhaltet, der mit einer Unterdruckquelle verbunden ist.

3. Reinigungsgerät gemäß Anspruch 1 oder 2, wobei mindestens:
sich die Plasmaradikalquelle zwischen ungefähr 1 mm und ungefähr 30 mm von der zu reinigenden Oberfläche befindet;
das Radikaleingrenzungssystem konfiguriert ist, um die zweite Strömung von Gas zu bilden, um die Radikale zu lenken;
die Plasmaradikalquelle konfiguriert ist, um eines von einer Quelle von reduzierenden Radikalen und einer Quelle von oxidierenden Radikalen zur Verfügung zu stellen; oder
die Plasmaradikalquelle und die Leitung so konfiguriert sind, dass im Wesentlichen keine lonen aus der Leitung geliefert werden.

4. Reinigungsgerät gemäß einem der Ansprüche 1 bis 3, wobei die Plasmaradikalquelle (46) eine Gasquelle (45) und eine Plasmaerzeugungsregion beinhaltet; und die Plasmaradikalquelle konfiguriert ist, um Gas aus der Gasquelle zuzuführen, so dass es durch die Plasmaerzeugungsregion zu der Leitung (48) gelangt;
wobei die Plasmaerzeugungsregion wahlweise ein Hochtemperaturelement beinhaltet, das sich innerhalb der Strömung von Gas befindet, wobei die Temperatur des Hochtemperaturelements ausreicht, um eine thermische Dissoziation zu bewirken, um die Radikale zu produzieren; und
die Gasquelle (45) wahlweise eine Zufuhr von aufbereiteter Luft bereitstellt.

5. Reinigungsgerät gemäß Anspruch 4, wobei die Plasmaerzeugungsregion mindestens eines von einer HF-Spule, einem Paar Wechselstrom- oder Gleichstrom-Entladungselektroden und einem Mikrowellen- oder HF-Hohlraum beinhaltet, der/die/das eine Region von Plasma innerhalb der Strömung von Gas aus der Gasquelle (45) erzeugt, wobei die Radikale in der Plasmaregion gebildet werden; wobei die Gasquelle (45) wahlweise eine Mischung aus einem Inertgas und einem Aktivgas bereitstellt; wobei das Inertgas mindestens eines von Stickstoff, Helium, Argon, Neon und Xenon ist und das Aktivgas eines von Sauerstoff und Wasserstoff ist; und das Aktivgas wahlweise zwischen ungefähr 0,5 % und ungefähr 2 %, und vorzugsweise ungefähr 1 %, des von der Gasquelle zugeführten Gases beträgt.

6. Reinigungsgerät gemäß einem der Ansprüche 1 bis 5, das ferner einen Rotator beinhaltet, der konfiguriert ist, um ein Substrat (W) relativ zu der Leitung (48) zu drehen; wobei das Radikaleingrenzungssystem (40) konfiguriert ist, um die Radikale zu einem örtlich begrenzten Abschnitt der Peripherie des Substrats zu lenken, so dass durch die Drehung des Substrats relativ zu der Leitung (48) der gesamte Umfang des Substrats gereinigt werden kann;
wobei die Leitung (48) die Radikale wahlweise auf einen Abschnitt der Kante des Substrats (W) lenkt;
die Leitung die Radikale wahlweise auf einen peripheren Abschnitt einer Hauptfläche des Substrats, auf der Vorrichtungen zu bilden sind, lenkt;
das Radikaleingrenzungssystem (40) wahlweise eine Schutzgasquelle beinhaltet, die konfiguriert ist, um eine Gasströmung (54), die einer Strömung von Radikalen aus der Leitung (48) entgegengesetzt ist, entlang mindestens einer Hauptoberfläche des Substrats (W) bereitzustellen, um das Ausmaß, in dem die Radikale auf die Oberfläche des Substrats gelangen, zu beschränken;
das Radikaleingrenzungssystem (40) wahlweise einen Gasextraktor (62) beinhaltet, der sich zwischen der Leitung und der Schutzgasquelle befindet und eingerichtet ist, um Radikale aus der Leitung und Gasströmung von der Schutzgasquelle zu extrahieren;
wobei das Reinigungsgerät wahlweise ferner einen Substrathalter beinhaltet, der konfiguriert ist, um das Substrat (W) zu halten; wobei der Rotator konfiguriert ist, um den Substrathalter relativ zu der Leitung zu drehen;
wobei das Reinigungsgerät wahlweise ferner eine Substrathalterung beinhaltet, die konfiguriert ist, um das Substrat (W) zu stützen; wobei der Rotator konfiguriert ist, um das Substrat relativ zu der Substrathalterung zu drehen;
wobei der Rotator wahlweise konfiguriert ist, um das Substrat (W) während der Reinigung zu stützen; und
wobei der Rotator wahlweise so konfiguriert ist, dass er in einem Modus betriebsfähig ist, um das Substrat (W) relativ zu der Leitung (48) zu drehen, und er mindestens einen anderen Modus aufweist, in dem er betriebsfähig ist, um das Substrat zwischen Orten zu bewegen.

7. Reinigungsgerät gemäß Anspruch 6, das installiert ist innerhalb eines von einem lithographischen Gerät, einer Transporteinheit, die konfiguriert ist, um ein Substrat (W) zu transportieren, und einer Substratverarbeitungseinheit, die konfiguriert ist für mindestens eines von Beschichten eines Substrats mit einem Photolack, Backen eines Substrats, Kühlen eines Substrats und Entwickeln einer Schicht aus Photolack auf einem Substrat, die mit einem gemusterten Strahl aus Strahlung belichtet worden ist.

8. Ein immersionslithographisches Gerät, das Folgendes beinhaltet:
ein Projektionssystem (PS) zum Vermitteln eines gemusterten Strahls auf ein Substrat (W);
eine Fluideingrenzungsstruktur (12) zum Eingrenzen von Immersionsfluid zwischen dem Projektionssystem und dem Substrat und/oder einem Substrattisch (WT), wobei der Substrattisch zum Stützen eines Substrats dient; und
ein Reinigungsgerät (42) gemäß einem der Ansprüche 1 bis 5, das eingerichtet ist, um einen örtlich begrenzten Abschnitt einer Oberfläche der Fluideingrenzungsstruktur (12) zu reinigen.

9. Ein immersionslithographisches Gerät, das Folgendes beinhaltet:
ein Projektionssystem (PS) zum Vermitteln eines gemusterten Strahls auf ein Substrat (W);
einen Substrattisch (WT) zum Stützen des Substrats;
eine Fluideingrenzungsstruktur (12) zum Eingrenzen von Immersionsfluid zwischen dem Projektionssystem (PS) und dem Substrat und/oder dem Substrattisch; und
ein Reinigungsgerät (42) gemäß einem der Ansprüche 1 bis 5, das eingerichtet ist, um einen örtlich begrenzten Abschnitt einer Oberfläche des Substrattisches zu reinigen.

10. Ein lithographisches Gerät, das Folgendes beinhaltet:
einen Substrathandhaber, der konfiguriert ist, um ein Substrat (W) auf einem Substrattisch (WT) zum Stützen des Substrats während der Belichtung zu positionieren, wobei der Substrathandhaber konfiguriert ist, um das Substrat vor dem Positionieren des Substrats auf dem Substrattisch zu drehen; und
ein Reinigungsgerät (42) gemäß einem der Ansprüche 1 bis 5, das konfiguriert ist, um einen örtlich begrenzten Abschnitt der Substratoberfläche zu reinigen, während sich das Substrat dreht.

11. Ein Verfahren zum Reinigen eines Substrats oder einer Komponente eines immersionslithographischen Geräts, wobei das immersionslithographische Gerät einen Substrattisch (WT) zum Stützen eines Substrats (W) und eine Fluideingrenzungsstruktur (12) zum Eingrenzen von Immersionsfluid zwischen einem Projektionssystem (PS) und einem Substrattisch und/oder Substrat beinhaltet, wobei das Verfahren Folgendes beinhaltet:
Bereitstellen einer Strömung von Radikalen in einer Gasströmung (49) unter Verwendung einer Plasmaradikalquelle (46);
Zuführen von Radikalen in der Gasströmung von der Plasmaradikalquelle (46) zu der zu reinigenden Oberfläche unter Verwendung einer Leitung (48); und
Lenken der Radikale in der Gasströmung unter Verwendung eines Radikaleingrenzungssystems (40), um einen örtlich begrenzten Abschnitt der Oberfläche zu reinigen;
wobei das Radikaleingrenzungssystem ein Absperrungsteil beinhaltet und das Verfahren ferner Folgendes beinhaltet:
Bereitstellen einer zweiten Strömung von Gas (54), so dass die Radikale im Wesentlichen auf dieselbe Seite des Absperrungsteils beschränkt werden wie der örtlich begrenzte Abschnitt der Oberfläche.

## Revendications

1. Un appareil de nettoyage (42) pour nettoyer un substrat ou un composant d'un appareil lithographique à immersion comprenant une table porte-substrat (WT) destinée à supporter un substrat (W) et un système de confinement de fluide (12) destiné à confiner le fluide d'immersion entre un système de projection (PS) et la table porte-substrat et/ou le substrat, l'appareil de nettoyage comprenant :
une source de radicaux plasma (46) destinée à fournir un flux de radicaux dans un flux gazeux (49) ;
une conduite (48) destinée à amener des radicaux dans le flux gazeux depuis la source de radicaux plasma jusqu'à la surface devant être nettoyée ; et
un système de confinement de radicaux (40) destiné à diriger les radicaux dans le flux gazeux afin de nettoyer une portion localisée de ladite surface ;
dans lequel le système de confinement de radicaux (40) comprend un élément formant barrière ; et dans lequel
le système de confinement de radicaux (40) est configuré pour fournir un deuxième flux de gaz (54) de manière à ce que les radicaux soient substantiellement limités au même côté de l'élément formant barrière que ladite portion localisée de ladite surface.

2. L'appareil de nettoyage de la revendication 1, dans lequel l'élément formant barrière est une chambre de confinement de radicaux au sein de laquelle est située la sortie de ladite conduite et, de manière facultative, la chambre de confinement de radicaux comprend une sortie (56) raccordée à une source de sous-pression.

3. L'appareil de nettoyage de la revendication 1 ou de la revendication 2, dans lequel au moins
soit la source de radicaux plasma est située à entre approximativement 1 mm et approximativement 30 mm de ladite surface à nettoyer ;
soit le système de confinement de radicaux est configuré pour former le deuxième flux de gaz afin de diriger les radicaux ;
soit la source de radicaux plasma est configurée pour procurer soit une source de radicaux réducteurs, soit une source de radicaux oxydants ;
soit ladite source de radicaux plasma et ladite conduite sont configurées de telle manière qu'il ne soit fourni substantiellement aucun ion depuis la conduite.

4. L'appareil de nettoyage de l'une quelconque des revendications 1 à 3, dans lequel la source de radicaux plasma (46) comprend une source de gaz (45) et une région génératrice de plasma ; et la source de radicaux plasma est configurée pour amener du gaz depuis ladite source de gaz de manière à ce qu'il passe à travers ladite région génératrice de plasma jusqu'à ladite conduite (48) ;
dans lequel, de manière facultative, la région génératrice de plasma comprend un élément à haute température situé au sein du flux de gaz, la température de l'élément à haute température étant suffisante pour occasionner une dissociation thermique afin de créer les radicaux ; et
de manière facultative, la source de gaz (45) fournit une alimentation en air purifié.

5. L'appareil de nettoyage de la revendication 4, dans lequel la région génératrice de plasma comprend au moins soit une bobine RF, soit une paire d'électrodes de décharge CA ou CC, soit une cavité micro-ondes ou RF qui génère une région de plasma au sein du flux de gaz provenant de la source de gaz (45), les radicaux étant formés dans la région de plasma ;
dans lequel, de manière facultative, la source de gaz (45) fournit un mélange d'un gaz inerte et d'un gaz actif ; dans lequel le gaz inerte est au moins soit l'azote, soit l'hélium, soit l'argon, soit le néon, soit le xénon ; et le gaz actif est soit l'oxygène, soit l'hydrogène ; et
de manière facultative, le gaz actif fait entre approximativement 0,5 % et approximativement 2 %, et de préférence approximativement 1 % du gaz que procure la source de gaz.

6. L'appareil de nettoyage selon l'une quelconque des revendications 1 à 5, comprenant en outre un rotateur, configuré pour faire tourner un substrat (W) relativement à ladite conduite (48) ;
dans lequel le système de confinement de radicaux (40) est configuré pour diriger les radicaux sur une portion localisée de la périphérie du substrat de telle sorte que, grâce à la rotation du substrat relativement à ladite conduite (48), le périmètre tout entier du substrat puisse être nettoyé ;
dans lequel, de manière facultative, ladite conduite (48) dirige les radicaux sur une portion du bord du substrat (W) ;
de manière facultative, ladite conduite dirige les radicaux sur une portion périphérique d'une face principale du substrat sur laquelle des dispositifs doivent être formés ;
de manière facultative, ledit système de confinement de radicaux (40) comprend une source de gaz protecteur configurée pour fournir un flux gazeux (54) en opposition à un flux de radicaux provenant de ladite conduite (48) le long d'une surface principale au moins du substrat (W) afin de limiter l'étendue sur laquelle les radicaux passent sur ladite surface du substrat ;
de manière facultative, le système de confinement de radicaux (40) comprend un extracteur de gaz (62), situé entre ladite conduite et ladite source de gaz protecteur, et arrangé pour extraire des radicaux provenant de ladite conduite et un flux gazeux provenant de ladite source de gaz protecteur ;
dans lequel, de manière facultative, l'appareil de nettoyage comprend en outre un porte-substrat, configuré pour porter le substrat (W) ; dans lequel le rotateur est configuré pour faire tourner le porte-substrat relativement à ladite conduite ;
dans lequel, de manière facultative, l'appareil de nettoyage comprend en outre une monture de substrat, configurée pour supporter le substrat (W) ; dans lequel le rotateur est configuré pour faire tourner le substrat relativement à la monture de substrat ;
dans lequel, de manière facultative, le rotateur est configuré pour supporter le substrat (W) pendant le nettoyage ; et
dans lequel, de manière facultative, le rotateur est configuré de telle manière que, dans un mode, il soit opérationnel pour faire tourner le substrat (W) relativement à la conduite (48) et il possède au moins un autre mode dans lequel il est opérationnel pour déplacer le substrat entre des emplacements.

7. Un appareil de nettoyage selon la revendication 6, installé soit au sein d'un appareil lithographique, soit au sein d'une unité de transport configurée pour transporter un substrat (W), soit au sein d'une unité de traitement de substrat configurée pour au moins soit enduire un substrat d'une réserve, soit cuire un substrat, soit refroidir un substrat, soit développer une couche de réserve sur un substrat qui a été exposé avec un faisceau de rayonnement à motif.

8. Un appareil lithographique à immersion comprenant :
un système de projection (PS) destiné à conférer un faisceau à motif sur un substrat (W) ;
une structure de confinement de fluide (12) destinée à confiner le fluide d'immersion entre le système de projection et le substrat et/ou une table porte-substrat (WT), la table porte-substrat étant destinée à supporter un substrat ; et
un appareil de nettoyage (42) selon l'une quelconque des revendications 1 à 5, arrangé pour nettoyer une portion localisée d'une surface de la structure de confinement de fluide (12).

9. Un appareil lithographique à immersion comprenant :
un système de projection (PS) destiné à conférer un faisceau à motif sur un substrat (W) ;
une table porte-substrat (WT) destinée à supporter le substrat ;
une structure de confinement de fluide (12) destinée à confiner le fluide d'immersion entre le système de projection (PS) et le substrat et/ou la table porte-substrat ; et
un appareil de nettoyage (42) selon l'une quelconque des revendications 1 à 5, arrangé pour nettoyer une portion localisée d'une surface de la table porte-substrat.

10. Un appareil lithographique comprenant :
un manipulateur de substrat configuré pour positionner un substrat (W) sur une table porte-substrat (WT) destinée à supporter le substrat pendant l'exposition, le manipulateur de substrat étant configuré pour faire tourner le substrat préalablement au positionnement du substrat sur la table porte-substrat ; et
un appareil de nettoyage (42) selon l'une quelconque des revendications 1 à 5,
configuré pour nettoyer une portion localisée de la surface de substrat à mesure que le substrat tourne.

11. Un procédé pour nettoyer un substrat ou un composant d'un appareil lithographique à immersion, l'appareil lithographique à immersion comprenant une table porte-substrat (WT) destinée à supporter un substrat (W) et une structure de confinement de fluide (12) destinée à confiner le fluide d'immersion entre un système de projection (PS) et la table porte-substrat et/ou le substrat, le procédé comprenant :
fournir un flux de radicaux dans un flux gazeux (49) à l'aide d'une source de radicaux plasma (46) ;
amener des radicaux dans le flux gazeux depuis la source de radicaux plasma (46) jusqu'à la surface devant être nettoyée à l'aide d'une conduite (48) ; et
diriger les radicaux dans le flux gazeux afin de nettoyer une portion localisée de ladite surface à l'aide d'un système de confinement de radicaux (40) ;
le système de confinement de radicaux comprenant un élément formant barrière et le procédé comprenant en outre :
fournir un deuxième flux de gaz (54) de manière à ce que les radicaux soient substantiellement limités au même côté de l'élément formant barrière que ladite portion localisée de ladite surface.
